Europäisches Patentamt

(19) European Patent Office

Office européen des brevets

(11) Publication number: **0 136 819**
**A2**

(12) **EUROPEAN PATENT APPLICATION**

(21) Application number: **84305933.8**

(22) Date of filing: **30.08.84**

(51) Int. Cl.⁴: **G 11 C 8/00**
**G 11 C 5/02**

(30) Priority: **05.09.83 JP 161838/83**

(43) Date of publication of application:
**10.04.85 Bulletin 85/15**

(84) Designated Contracting States:
**DE FR GB IT**

(71) Applicant: **HITACHI, LTD.**
**6, Kanda Surugadai 4-chome Chiyoda-ku**
**Tokyo 100(JP)**

(72) Inventor: **Ito, Kiyoo**
**2-17-6, Gakuen-cho**
**Higashi-kurume-shi Tokyo(JP)**

(72) Inventor: **Hori, Ryoichi**
**2196-125, Hirai Hinode-machi**
**Nishitama-gun Tokyo(JP)**

(74) Representative: **Calderbank, Thomas Roger et al,**
**MEWBURN ELLIS & CO. 2/3 Cursitor Street**
**London EC4A 1BQ(GB)**

(54) **Semiconductor memory.**

(57) A semiconductor memory has a plurality of data lines ($Y_0$ to $Y_3$), a plurality of word lines ($X_0$ to $X_3$) which are arranged so as to intersect the plurality of data lines ($Y_0$ to $Y_3$), and a plurality of memory cells (MC) which are provided at intersection points of the plurality of data lines ($Y_0$ to $Y_3$) and the plurality of word lines ($X_0$ to $X_3$). A row decoder (3) selects at least one of the plurality of word lines ($X_0$ to $X_3$), and a column decoder (4) generates a signal for connecting one of the plurality of data lines ($Y_0$ to $Y_3$) to an input/output line I/O. A plurality of wiring leads (P) are formed of a conductor layer different from conductor layers forming the plurality of data lines ($Y_0$ to $Y_3$) and the plurality of word lines ($X_0$ to $X_3$) are arranged so as to intersect the plurality of data lines ($Y_0$ to $Y_3$). In this way the area of the semiconductor chip 1, on which the memory is formed, may be reduced.

FIG. 2A

EP 0 136 819 A2

# SEMICONDUCTOR MEMORY

The present invention relates to a semiconductor memory.

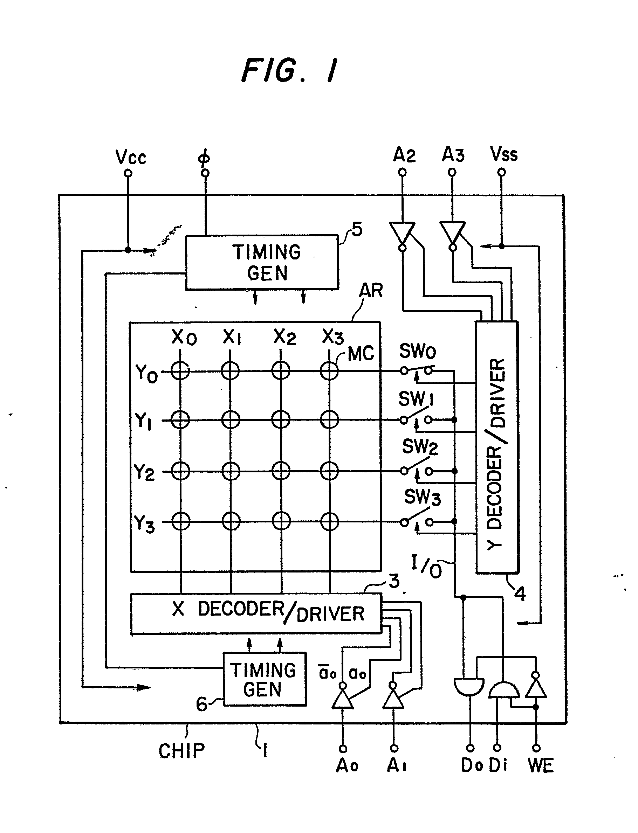

As illustrated in Fig. 1 of the accompanying drawings, a known semiconductor memory has a memory array AR of memory cells MC formed on a chip 1. An X decoder (including a driver) 3 selects memory cells MC in a row direction, and a Y decoder (including a driver) 4 selects memory cells MC in a column direction. Also shown in Fig. 1 are timing generator circuits 5 and 6, and an address driver etc. The timing generator circuits 5 and 6 produce various internal timing pulses in synchronism with a clock pulse so as to control various circuit operations. Supply voltages $V_{CC}$ (for example, 5 volts) and $V_{SS}$ (0 volt) are fed to the circuits. Usually, a wiring material of low resistivity such as aluminium is used for power source lines for the supply voltages $V_{CC}$ and $V_{SS}$ or timing signal lines for various internal timings. Aluminium of the same layer is used within the memory array AR.

In such prior-art semiconductor memory, a reading operation is performed as stated below. When external address signals $A_0$ - $A_3$ are received as inputs, the X decoder 3 is started. When a word line $X_0$, for example, is consequently selected from among a plurality of word lines $X_0$ - $X_3$, a select pulse is delivered to the word line $X_0$, and the memory cells MC connected therewith deliver read signals to corresponding data lines $Y_0$ - $Y_3$. Meanwhile, assuming that a select signal from the Y decoder 4 applied through a Y control line 8 turns on a switch $SW_0$ to select the data line $Y_0$, the signal read out to the data line $Y_0$ is delivered to an input/output line I/O through the switch $SW_0$ and is externally provided as a data output $D_0$. In a writing operation, a data input $D_i$ is sent to the input/output line I/O, the switch $SW_0$ and the data line $Y_0$ by a write enable signal WE, and the data is written into the memory cell MC which is connected at the intersection point between the data line $Y_0$ and the selected word line $X_0$.

In such semiconductor memory, however, the power source lines of the supply voltages $V_{CC}$, $V_{SS}$ as well as the lines of the various timing signals and the memory array employ the identical conductor layer, so that they must be formed in regions separate from each other, making it impossible to reduce the area of the chip.

For example, when the semiconductor memory is encased in a dual in-line package, the shorter side of the chip needs to be made small. However, the construction of the prior art devices has limited any reduction in this dimension.

According to the present invention, wiring leads such as power source lines and various timing signal lines extend in a direction intersecting the data lines of the memory array, and these wiring leads are formed within the memory array by the use of a conductor layer different from that forming the word lines and the data lines. Thus, it is possible to reduce the region to be occupied by the wiring leads and the area of the chip occupied by the memory array may be reduced. Also, since the wiring leads extend in a direction intersecting the data lines, there is little capacitive coupling of the wiring per data line, and the data lines are not significantly affected by the signals of the wiring leads. In contrast, when the data lines and the wiring leads are arranged in parallel, capacitive coupling increases and greatly affects the data lines having small signals, so that there is a risk of malfunction of the semiconductor memory.

Embodiments of the present invention will now be described, by way of example, with reference to the accompanying drawings, in which:

Fig. 1 is a diagram of the arrangement of a prior-art semiconductor memory;

Fig. 2A is a diagram of the arrangement of an embodiment of the present invention, while Fig. 2B is a sectional view taken along line A - A' in Fig. 2A;

Figs. 3 - 6 are diagrams each showing the arrangement of another embodiment of the present invention;

Fig. 7 is a diagram of the arrangement of a subarray for use in the embodiment of Fig. 5A or 6, while Fig. 8 is a time chart of the operation of the subarray in Fig. 7;

Figs. 9 - 12 are diagrams each showing the arrangement of another embodiment of the present invention;

Figs. 13 - 15 are diagrams each elucidating the way of connection in the case of arranging X and Y decoders in parallel;

Fig. 16 is a diagram showing a semiconductor memory constructed by combining the various embodiments of the present invention;

Fig. 17A is a layout plan of a folded bit line arrangement cell for use in the semiconductor memory of Fig. 16, Fig. 17B is a circuit diagram of the folded bit line arrangement cell, and Fig. 17C is a sectional view of the folded bit line arrangement cell;

Fig. 18 is a diagram showing a part of the circuit arrangement of Fig. 16 in detail; and

Figs. 19 - 24 are diagrams each showing an example in the case of arranging the X and Y decoders of open data line arrangement memory cells in parallel.

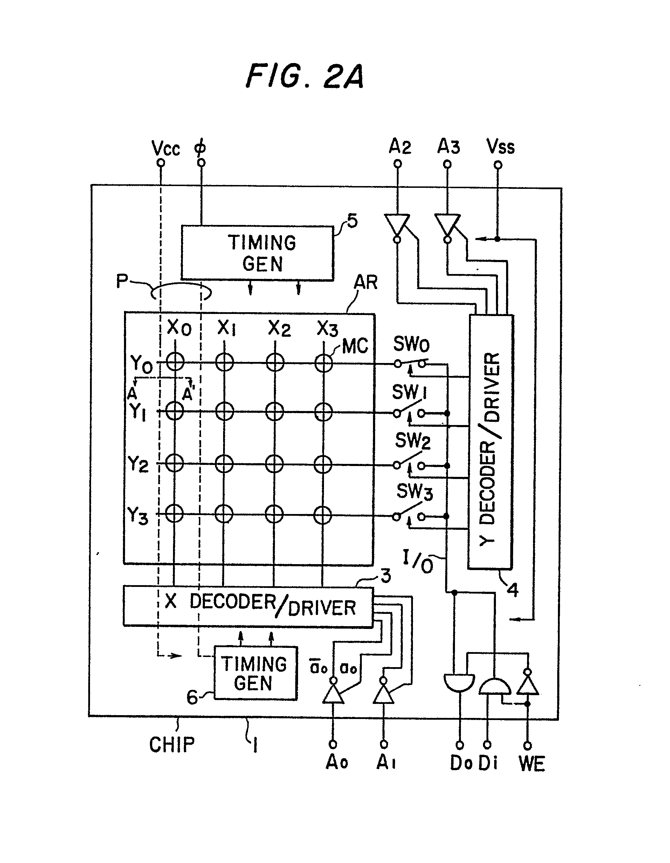

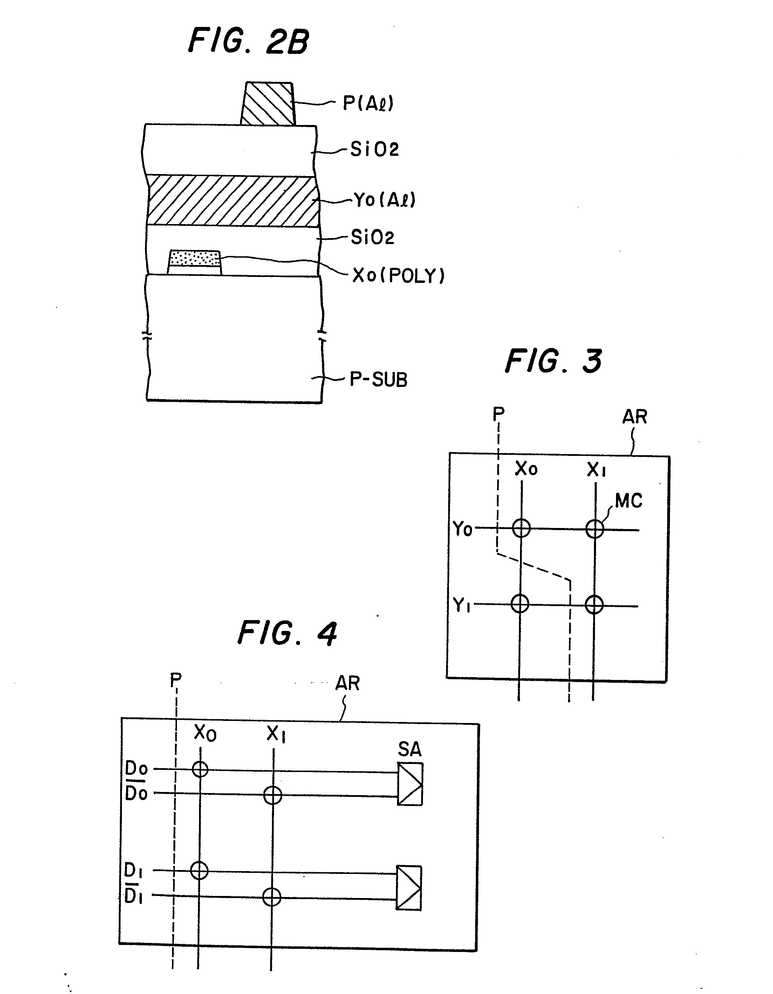

Fig. 2A shows one embodiment of the present invention, in which the same parts as in Fig. 1 are assigned the same symbols. Fig. 2B is a sectional view taken along line A - A' in Fig. 2A.

The point of difference from the prior art in Fig. 1 is that wiring leads P, such as power source lines and various timing signal lines, are arranged so as to intersect the data lines $Y_0 - Y_3$ within the memory array AR. In this first embodiment, the word lines $X_0 - X_3$ are formed of a self-alignment material such as polycrystalline silicon or silicide, the data lines $Y_o - Y_3$ are formed of a first layer of aluminum, and the power source lines and various timing signal lines P are formed of a second layer of aluminum. The wiring lead P, the data line $Y_0$ and the word line $X_0$ are insulated therebetween by insulator films ($SiO_2$). They are formed on a P-type silicon substrate.

In Fig. 2B, in order to facilitate understanding, the data line is also depicted as if seen in section.

According to the present embodiment, the power
source line  and various timing signal lines P pass
within the memory array AR, and hence, the shorter side
of the chip can be shortened to that extent.  Moreover,
since the various timing signal lines intersect the
data lines $Y_0 - Y_3$, coupled capacitances are smaller
than in the case of arraying them in parallel, and the
small  read signals of the data lines are less affected.

Although, in the present embodiment, all of the
power source line  and various timing signal lines P
are arranged on the memory array AR, only some of them
need     be arranged on the memory array.  In this case,
the shorter side of the chip can be reduced to the extent
of the occupying area of the lines arranged on the memory
array.

Fig. 3 shows another embodiment of the present
invention.  In the example of Fig. 2A, the influence
of the capacitive coupling on the small  signals of
the data lines is little, but the capacitive coupling
of the wiring leads with the word lines arises.  This
second  embodiment is appropriate when this capacitive
coupling becomes a problem.  In Fig. 3, only the word
lines $X_0$, $X_1$ and the data lines $Y_0$, $Y_1$ are illustrated.

Concretely, the power source line and the various
timing signal lines are coupled to the plurality of

word lines $X_0$, $X_1$. To this end, the power source line and various timing signal lines P                    intersect one word line and are passed near the other word line. This is the point of difference from the circuit of Fig. 2. Thus, it is possible to reduce voltages which couple from the power source line and various timing signal lines to the word lines $(X_0 - X_1)$ and voltages which couple from one selected word line to the power source line and various timing signal lines conversely. Consequently, this measure eliminates the drawback that, since the power source line and various timing signal lines are close to a specified word line (for example, the word line $X_0$), only this word line has an increased capacitance as compared with another word line (for example, the word line $X_1$) and is hampered from operating at high speed. In a case where the power source line is thick and extends over a plurality of word lines, it may                    intersect the plurality of word lines.

Fig. 4 shows another embodiment of the present invention, having improvements in the circuit of Fig. 2A.

This third embodiment is the application of the present invention to a folded bit line arrangement cell. The detailed structure of the folded bit line arrangement cell is described in, e. g., IEEE PROC., Vol. 130, Pt. I.

No. 3, p. 127, June 1983.

Data lines are constructed of pair lines D and $\overline{D}$, and a memory cell MC which is composed of a transistor and a capacitor is connected to one of the two intersection points between the pair lines and a word line X. The points of difference from Fig. 2A are that the signals of the two data lines are differentially amplified by a sense amplifier SA, and that these two data lines intersect the same timing signal line P.

In the third embodiment, even when the various timing signal lines P couple to the two data lines capacitively, voltages generated by the capacitive coupling become inphase between the two data lines and are cancelled at the differential amplification. For this reason, the capacitive coupling of the various timing signal lines affects the reading of data very slightly.

In order to reduce voltages which are generated contrariwise by the capacitive coupling of the data lines to the various timing signal lines, a half precharge system may be adopted. This system is such that, before stored information is read out from a memory cell, data lines are precharged to the intermediate level of two voltages "1" and "0" to be written into the memory cell. It is described in, for example, the official gazette

- 9 -                                    0136819

of Japanese Patent Application Laying-open No. 54-63632
or ISSCC 1984 Digest of Technical Paper, p. 276, "A
288kb CMOS Pseudo SRAM" and p. 278, "A Sub 100ns 256k
DRAM in CMOS III Technology".

With this system, in differentially amplifying
the signals by means of the sense amplifier, a change
at the time at which the signal of one·of the paired
data lines becomes a high potential is substantially
equal to a change at the time at which the signal of
the other data line becomes a low potential, so that
potentials attributed-to the capacitive coupling of
the two data lines are cancelled.

In the third embodiment of Fig. 4, the folded
bit line arrangement cell has been exemplified.  However, insofar as two paired lines whose signals are
to be differentially amplified are juxtaposed and the
wiring lead P such as the timing signal line is laid
so as to intersect the paired lines respectively, noise
components attributed to the capacitive coupling between
the wiring lead P and the data lines are cancelled.
This holds true of a flip-flop type static memory.

More specifically, the flip-flop type static memory
has signal lines in a relationship complementary to
each other for one memory cell.  Since the complementary
signal lines are laid in common for a plurality of memory cells, they are arranged in parallel with each other. Accordingly, the wiring lead P such as the timing signal line can be laid so as to intersect the complementary signal lines respectively, as in the case of the folded bit line arrangement cell, and the noise components ascribable to the capacitive coupling between the wiring lead P and the data lines are cancelled.

Next, there will be elucidated an embodiment wherein the present invention is applied to a memory of the multi-divided data line system which is described in U. S. Patent Application No. 380409 (corresponding to Japanese Patent Application Laying-open No. 57-198592).

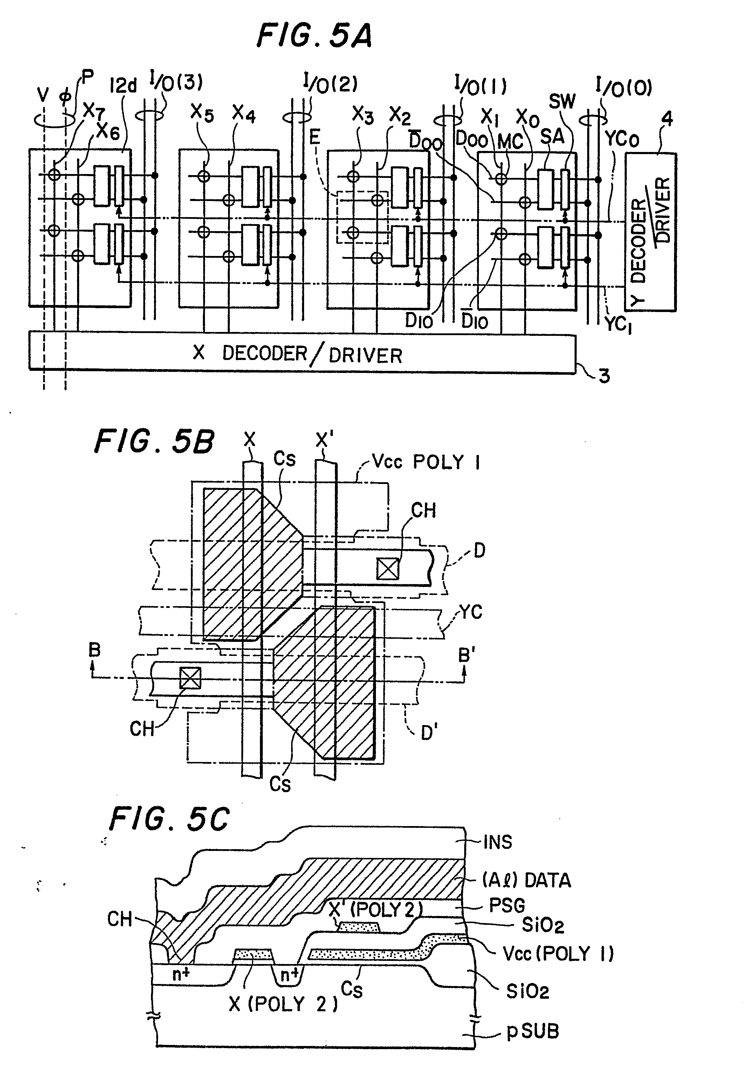

Fig. 5A shows an example in which a large number of sub arrays 12a - 12d are driven by a single Y decoder. Each of the sub arrays is constructed of folded bit line arrangement cells. One of the word lines $X_0$ - $X_7$ of the respective sub arrays is selected by an X decoder 3 (including a driver). Each of the sub arrays 12a - 12d is provided with one pair of input/output lines I/O. When note is taken of the sub array 12a, the signal of the memory cell MC connected to the word line $X_0$ selected by the X decoder 3 appears on a sub data line $D_{00}$. After the signals of a sub data line pair $D_{00}$, $\overline{D_{00}}$ have been differentially amplified by a sense amplifier SA, a switch SW is driven by means of a Y control line $YC_0$ selected by the Y decoder 4, and the amplified signals are read out on one pair of input/output lines I/O(0). The other sub arrays 12b - 12d have similar arrangements. The switches SW of the respective sub arrays are driven by common Y control lines $YC_0$ and $YC_1$. For example, where the Y control line $YC_0$ has been selected, the signals of one sub data line pair are read out from each of the sub arrays 12a - 12d to the corresponding one of the input/output lines I/O(0) - I/O(3).

In this fourth embodiment, the wiring leads P, which consists of the power source line for feeding a supply voltage V and the signal lines of various timings (in the figure, only $\phi$ is illustrated), are formed by the same conductor layer as that of the Y control lines $YC_0$, $YC_1$. Accordingly, in order to prevent the wiring leads P and the Y control lines from overlapping, the switches are disposed on the side of the sub array 12d near to the Y decoder 4, whereby the Y control lines parallel to the sub data lines are prevented from extending deep into the sub array 12d. Thus, the wiring leads P which orthogonally intersect the sub data lines can be arranged within the sub array 12d.

Fig. 5B is a layout pattern of the part E of Fig. 5A enclosed with a dotted line.  Fig. 5C is a sectional view taken along line B - B' in Fig. 5B.

The storage capacitance $C_s$ of the memory cell, which is a hatched part in Fig. 5B, is formed between a first layer of polycrystalline silicon (POLY1 in Fig. 5C) and a p-type substrate  pSUB with a thin oxide film $SiO_2$ held therebetween.  The data line D' is formed of a first layer of aluminum which is connected with a diffused layer $n^+$ through a contact hole (CH in the figures).  Symbol INS in Fig. 5C denotes an inter-layer insulator film which is located between the data line D' and the Y control line YC.  The word lines X are formed of a second layer of polycrystalline silicon (POLY2).  Further, broken lines in Fig. 5B indicate the data lines.  Indicated by a two-dot chain line is the Y control line, which is formed of a second layer of aluminum that lies over the first layer of aluminum. The wiring leads P are formed of the second layer of aluminum likewise to the Y control lines.

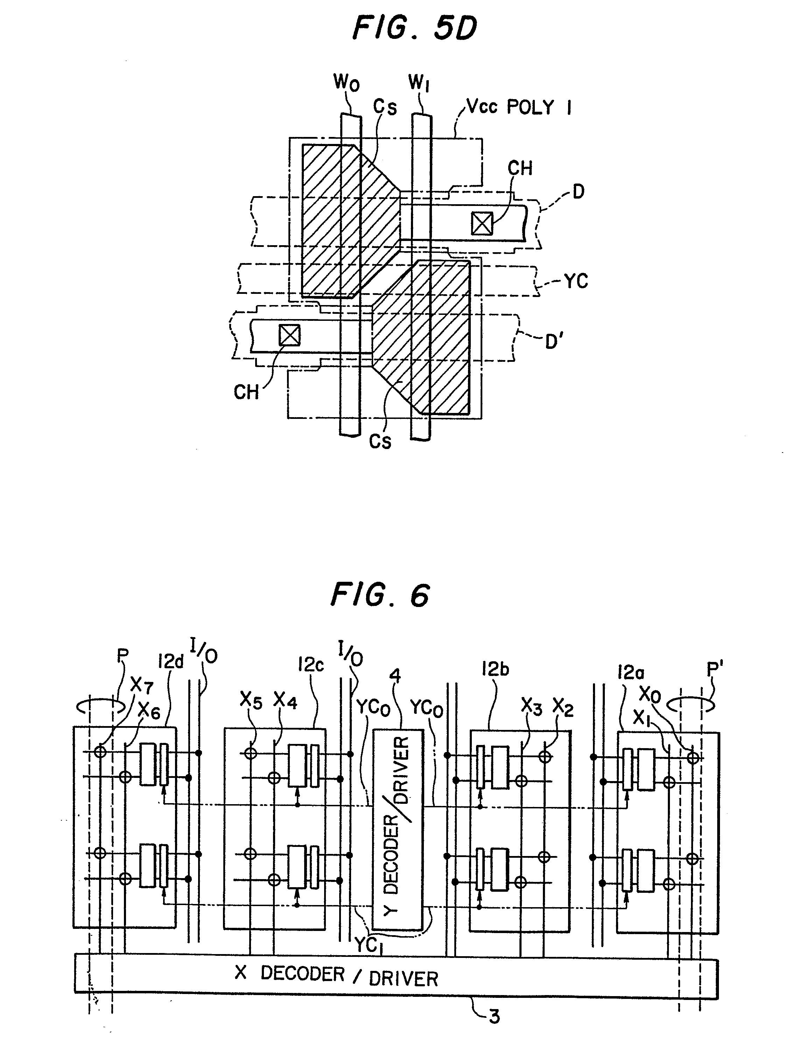

Fig. 5D is a diagram of another layout of the part E of Fig. 5A enclosed with the dotted line.  The difference from Fig. 5B is that the sub data lines D, D' and the Y control line YC are formed of the same conductor layer or the first layer of aluminum.  In the figure, therefore, the sub data lines D, D' and the Y control line YC are indicated by the same dotted lines.  Since the sub data lines and the Y control lines are arranged in parallel and do not overlap each other, they can be formed of the same conductor layer. In this case, as in the layout of Fig. 5B, the wiring leads P are formed of the second layer of aluminum, and the word lines are formed of    self-alignment material such as polycrystalline silicon.

According to the layout of Fig. 5D, the wiring leads P orthogonally intersecting the sub data lines and the Y control lines extending in parallel therewith are not of the same conductor layer, the wiring leads P can be arranged using the entire region on the sub array.

When the power source line and various timing signal lines are formed of the second layer of aluminum, the X decoder is recommended to be laid out by the use of the first layer of aluminum. This measure facilitates the layout because it is free from the trouble of changing the connection of the power source line and various timing signal lines to another conductor layer in the X decoder portion and then passing the lines within the X decoder.

Fig. 6 shows an embodiment which has improved the circuit arrangement of Fig. 5A. The same parts as in Fig. 5A are assigned the same symbols.

The point of difference from the circuit arrangement in Fig. 5A is that the Y decoder 4 is arranged between the sub arrays, and that the Y control lines $YC_0$, $YC_1$ are extended bidirectionally so as to drive the sub arrays on both sides of the Y decoder. In order to balance the Y control lines, the numbers of the sub arrays on both the sides are equalized.

In this fifth embodiment, not only the sub array 12d, but also the sub array 12a is provided with a space in which the power source line $V_{CC}$ and various timing signal lines P' are arranged without passing the Y control lines $YC_0$, $YC_1$. In the case of forming the Y control lines and the wiring leads P by the use of the same conductor layer, therefore, the fifth embodiment can furnish the power source and timing signal lines with an area double that of the circuit arrangement in Fig. 5A.

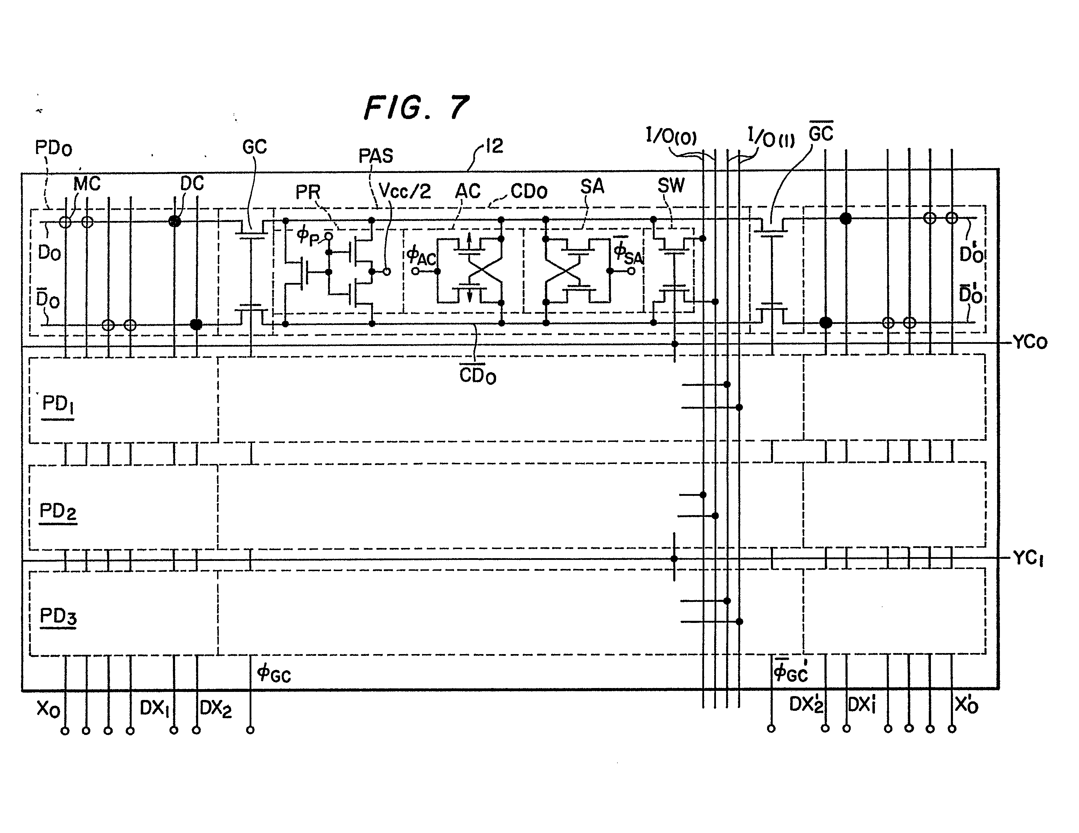

Fig. 7 shows an embodiment which has improved the sub arrays of the circuit arrangements in Fig. 5A and Fig. 6.

Data lines $D_0$, $\overline{D_0}$ are connected to nodes $CD_0$, $\overline{CD_0}$ through a switching circuit GC. Data lines $D_0'$, $\overline{D_0}'$ are also connected to the nodes $CD_0$, $\overline{CD_0}$ through a switching circuit $\overline{GC}$. A sense amplifier SA, an active restore circuit AC, a precharge circuit PC and a switching circuit SW are connected to the nodes $CD_0$, $\overline{CD_0}$. In

the figure, four sets of circuits PD ($PD_0$, $PD_1$, $PD_2$ and $PD_3$) in each of which they are combined are shown.

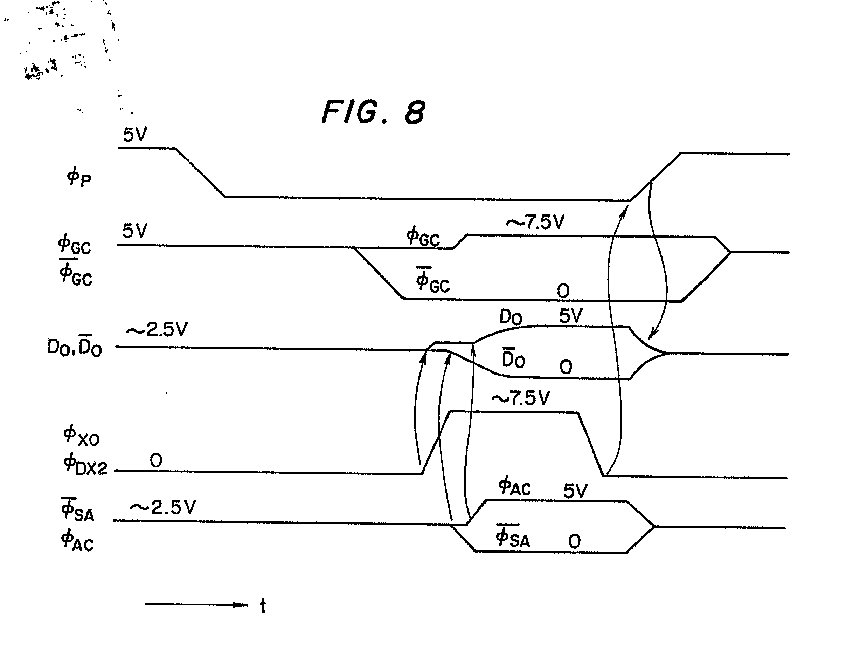

The embodiment will be described more in detail with reference to a time chart in Fig. 8. First, in accordance with a precharge signal $\phi_p$, the precharge circuit PC precharges all the nodes ($D_0$, $\overline{D_0}$, $CD_0$, $\overline{CD_0}$, $D_0'$, $\overline{D_0'}$, etc.) to $\frac{1}{2} V_{CC}$. This is called "half precharge". When a word line $X_0$ is selected by an X decoder (not shown) to provide a word pulse $\phi_{xo}$, a memory cell MC connected thereto is selected. Thus, a minute signal voltage which is determined by the storage capacitance $C_s$ of the memory cell MC and the capacitance of the data line $D_0$ is delivered to this data line.

Simultaneously, a reference voltage is delivered from a dummy cell DC to the data line $\overline{D_0}$ by turning on a pulse $\phi_{rx2}$. The dummy cell DC is not particularly needed in the half precharge system, but the use thereof is more effective when it is desired to cancel noise components.

Before the word line $X_0$ is selected, the switching circuit $\overline{GC}$ connected to the data lines ($D_0'$, $\overline{D_0'}$) on the side to which the memory cell MC to be selected belongs is turned off by a control signal $\overline{GC}$. On the other hand, the switch GC remains turned on. Accordingly, signals corresponding to the information from the memory cell MC appear at the nodes $D_0$, $CD_0$, while the reference

voltage from the dummy cell DC appears at the nodes $\overline{D_0}$, $\overline{CD_0}$. The reference voltage is set at substantially an intermediate potential between read voltages which appear at the node $CD_0$ in correspondence with the information "1" and "0" of the memory cell MC. Therefore, a minute differential voltage corresponding to the information "1" or "0" appears at the input end of the sense amplifier SA. Thereafter, the sense amplifier SA is operated by a start pulse $\overline{\phi_{SA}}$ so as to amplify the differential voltage. Since the sense amplifier SA is formed of n-channel MOSFETs, it cannot charge the node $CD_0$ or $\overline{CD_0}$ though it can discharge the same. Therefore, the active restore circuit AC is operated by a start pulse $\phi_{AC}$ so as to perform the charging. To this end, the active restore circuit AC is formed of p-channel MOSFETs.

Thereafter, a control signal is delivered to the Y control line $YC_0$ selected by a Y decoder (not shown), and the amplified voltage is differentially delivered to paired common input/output lines I/0(0) via the switch SW. Input/output lines I/0(0), I/0(1) are formed of the same conductor layer as that of the power source line or various timing signal lines.

The merits of the present circuit arrangement are as follows. Since the common input/output lines are

- 17 -

0136819

laid near the sense amplifier SA, data can be read and written at high speed. In addition, since the precharge circuit, sense amplifier and active restore circuit are common to the two data line pairs, the area decreases to that extent.

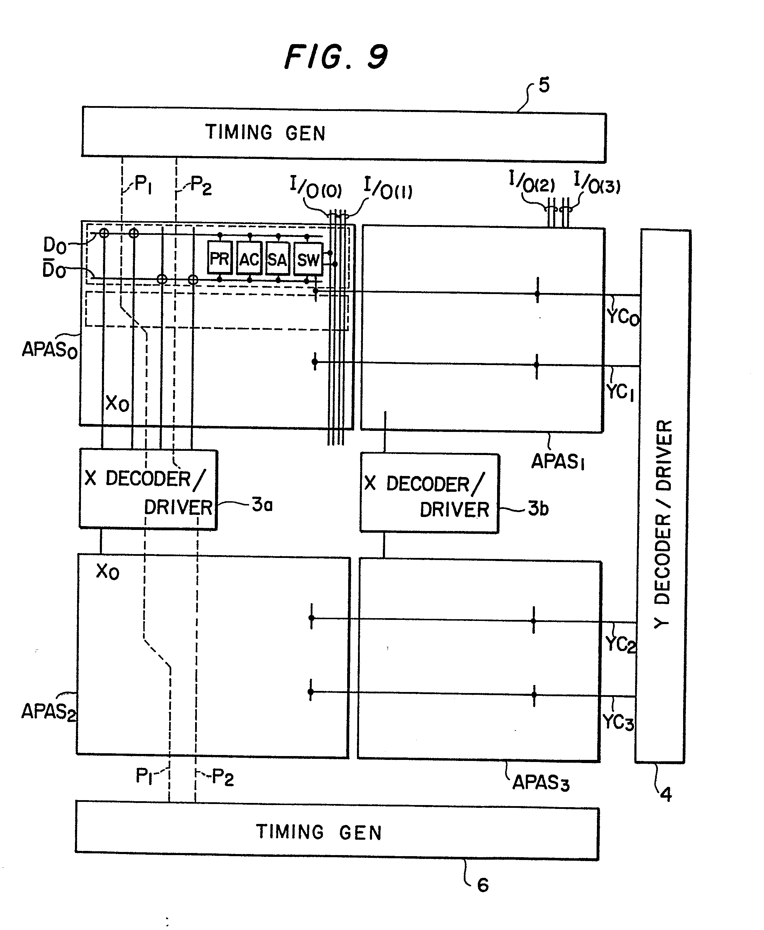

Fig. 9 shows an example in which the word lines are divided into sub word lines as to the two sub arrays 12a and 12b of the circuit arrangement in Fig. 5A.

The sub array 12a in Fig. 5A is divided into arrays APAS0 and APAS2 in the lengthwise direction of the word lines, and the other-sub array 12b into arrays APAS1 and APAS3. X decoders 3a and 3b are disposed between the respective divided arrays.

The memory has a folded bit line arrangement cells as shown in Fig. 7. However, in the circuit arrangement of Fig. 7, the single sense amplifier SA, precharge circuit PR, active restore circuit AC and switch SW are shared by the two pairs of data lines, whereas in the embodiment of Fig. 9, a single sense amplifier etc. are employed for one pair of data lines. Accordingly, the present embodiment differs from the circuit arrangement of Fig. 7 in that the switching circuits GC, $\overline{GC}$ are not present, but it is the same in regard to the other circuits.

Timing signal lines $P_1$, $P_2$ between timing generator

circuits 5 and 6 for generating various timing signals are formed of the second layer of aluminum similarly to Y control lines $YC_0 - YC_3$ extended from a Y decoder 4.

Since, in the present embodiment, folded bit line arrangement cells are employed, the switches SW are disposed on one side of the arrays nearer to the Y decoder 4. Accordingly, the Y control lines $YC_0 - YC_3$ from the Y decoder 4 extend to intermediate positions of the outer arrays APASO, APAS2 as viewed from the Y decoder 4 and are connected to the switches SW. The timing signal lines between the timing generator circuits can therefore be arranged in the remaining regions of the arrays APASO, APAS2.

The timing signal lines $P_1$, $P_2$ are arranged so as to couple with a plurality of sub word lines to avoid the influence of a malfunction ascribable to the capacitive coupling with the sub word line, as illustrated in Fig. 3. By way of example, the timing signal line $P_1$ is bent within the array so as to be also coupled with another word line, while the timing signal line $P_2$ is bent between the arrays so as to be also coupled with another sub word line.

In the arrangement of Fig. 9, only some of the four arrays APASO - APAS3 are sometimes operated at the same time without operating all of them. This includes the following two cases:

(1) By driving the X decoder 3a and the Y decoder 4, the arrays in the direction of the sub word lines, such as the arrays APAS0 and APAS2, are operated.

In this case, the voltage fluctuations of the data lines existing directly below the timing signal lines $P_1$, $P_2$ take place over the full lengths of the timing signal lines, so that great noise voltages are induced on the timing signal lines $P_1$, $P_2$ through the coupled capacitances between the timing signal lines and the data lines.

(2) The upper or lower sub word lines of the X decoders 3a and 3b are separately driven, whereby the sub arrays in the direction of the data lines, such as the arrays APAS0 and APAS1, are operated.

In this case, the voltage fluctuations of the data lines existing directly below the timing signal lines $P_1$, $P_2$ take place in only a half of the region in the above case, so that noise voltages decrease to half.

When driving some of the arrays, accordingly, it is preferable to operate the sub arrays in the direction of the data lines.

In the arrangement of Fig. 9, the Y control lines $YC_0$ - $YC_3$ and the data lines may be made of the first layer of aluminum, and the timing signal lines $P_1$, $P_2$ the second layer of aluminum.

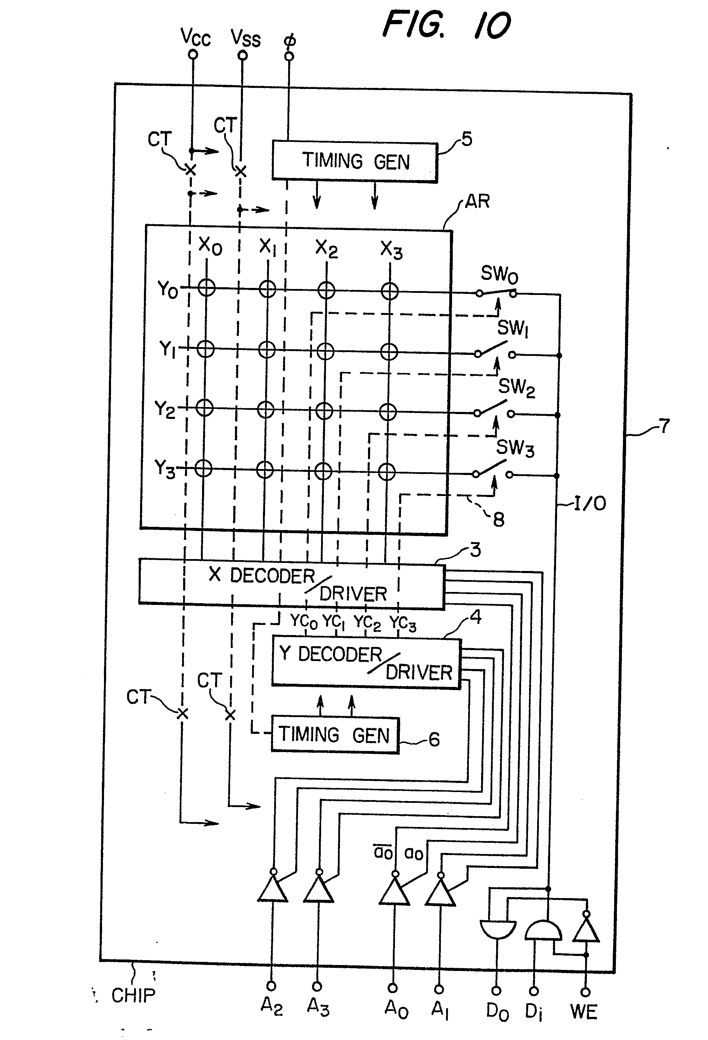

Next, Fig. 10 shows an example in which the Y decoder is disposed in parallel with the X decoder in order to more reduce the shorter side of the chip.

Different from the arrangement of Fig. 2A is that the Y decoder 4 is juxtaposed to the X decpder 3.

The power source lines and timing signal lines are laid in the direction orthogonally intersecting the data lines.

Since, in the present embodiment, the Y decoder is         in parallel with the X decoder, the Y control lines which control the switches for connecting the data lines and the input/output lines must be arranged on the memory array so as to avoid increase in the occupying area attributed to the prolongation of the Y control lines.  To this end, the power source lines and timing signal lines are formed of the same layer as that of the Y control lines 8; and they are arranged on that part of the memory array which is other than the region for the Y control lines 8.

For example, when the memory array AR in the prior art is formed of a diffused layer, polycrystalline silicon or aluminum, two layers of aluminum may be formed so as to lay the Y control lines $YC_0$ - $YC_3$ by the use of the second layer of aluminum.  The power source lines and various internal timing signal lines can be passed within the memory array 2 by, for example, changing them from the wiring leads of the first layer of aluminium to those of the second layer of aluminium via through holes midway (points CT in the figure).

Thus, the length of one side of the chip may be shortened in correspondence with the change in size of the Y decoder 4, the power source lines etc. There is, however, a corresponding increase in the length of the other side of the chip, but this is not a serious problem in practical use. The reason is that in a dual in-line package, the length of the longer side of the chip is relatively surplus, as is apparent from the shape of the chip. The pitch of the word lines $X_0 - X_3$ and that of the Y control lines $YC_0 - YC_3$ need not always be the same. For example, if the pitch of the Y control lines $YC_0 - YC_3$ is made smaller, the power source lines and internal timing signal lines may be passed within the array in a larger number to that extent. Therefore, the number of wiring leads which are inevitably laid outside the array decreases, and in effect, the length of the shorter side of the chip can be rendered still smaller.

If the embodiment of Fig. 10, the Y control lines 8 and the power source lines are formed of the same conductor layer. It is also possible, however, to form the Y control lines by the use of the second layer of aluminum and the power source lines by the use of a third layer of aluminum.

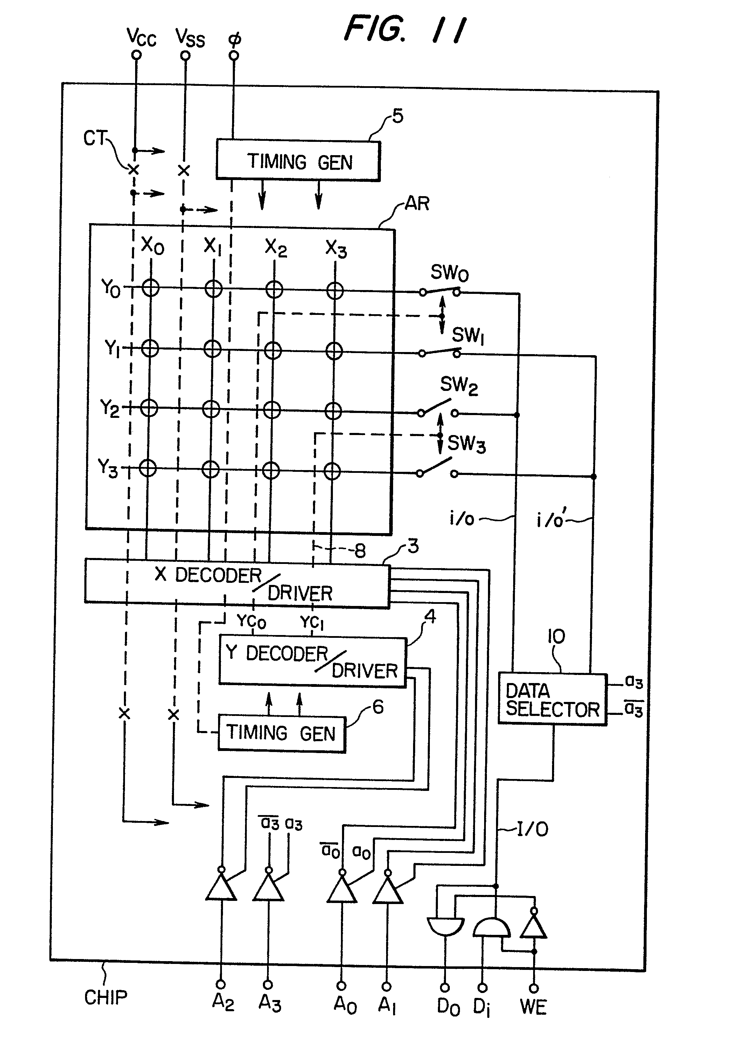

Fig. 11 shows a modified embodiment of the circuit arrangement in Fig. 10. Using a single Y control line, e. g., $YC_0$, the switches $SW_0$, $SW_1$ are simultaneously controlled to connect two input/output lines i/o, i/o' with the respectively corresponding data lines $Y_0$, $Y_1$. One of the two input/output lines i/o, i/o' is selected by a data selector circuit 10, and is connected to the input/output line I/θ.

Thus, the exchange signals of the input/output lines i/o, i/o' are controlled by the data selector circuit 10. The merit of the present system is that the semiconductor memory is easy to manufacture because the pitch of the control lines 8 can be rendered large. In a case where the number of bits in the memory array is still larger, four or eight switches can also be controlled at once by the single Y control line 8.

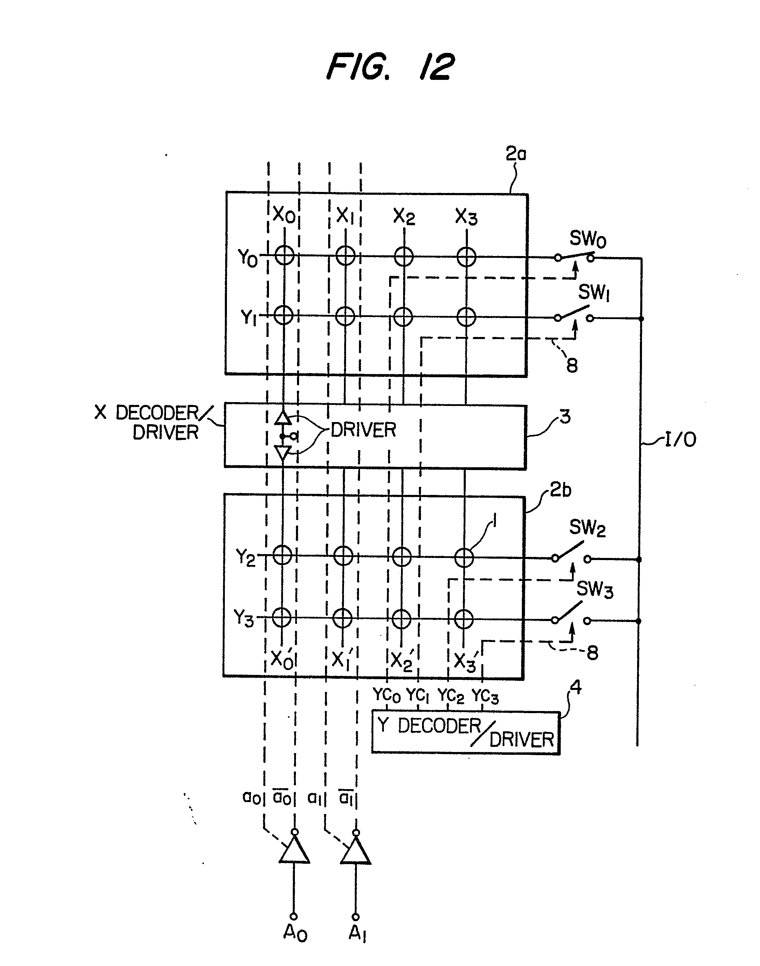

Fig. 12 shows another modification of the circuit arrangement in Fig. 10. In this modification, the same portions are assigned the same symbols.

The point of difference from the circuit arrangement in Fig. 10 is as stated below. In order to eliminate the delay of word lines attributed to the resistance components thereof in a case where the word lines are formed of a resistive material, for example, polycrystalline silicon or silicide, the memory array is divided into portions 2a and 2b, between which the X decoder 3 is disposed. Thus, the word lines are divided into sub word lines ($X_0 - X_3$, $X_0' - X_3'$), and the length per word line is shortened.

This arrangement can reduce the resistance components of the word lines and shorten the delay times thereof.

Since, in the present embodiment, the X decoder is between the memory arrays 2a and 2b, address signal lines $a_0$, $\overline{a_0}$, $a_1$ and $\overline{a_1}$ to be connected to the X decoder are arranged on the memory array. When, as stated before, the address signal lines are formed of a conductor layer different from that of the memory array in the prior art, they can be arranged on the memory array. As a modification of the present embodiment, an arrangement is also possible in which a plurality of sets each consisting of the memory array 2a, the X decoder 3 and the memory array 2b are repeated in the vertical direction and in which the Y decoder 4 and the address signal lines $a_0 - \overline{a_1}$ can be used in common for the repeated sets. In this case, there is the advantage that the chip area can be reduced in correspondence with the parts omitted owing to the common use.  Besides, if necessary, the Y decoder 4 can be placed between the memory arrays 2a and 2b in adjacency to the X decoder 3.  Thus, the power source lines etc. can be rendered common to the X decoder 3 and the Y decoder 4 owing to the close positions thereof, so that the chip area can be furthermore reduced.

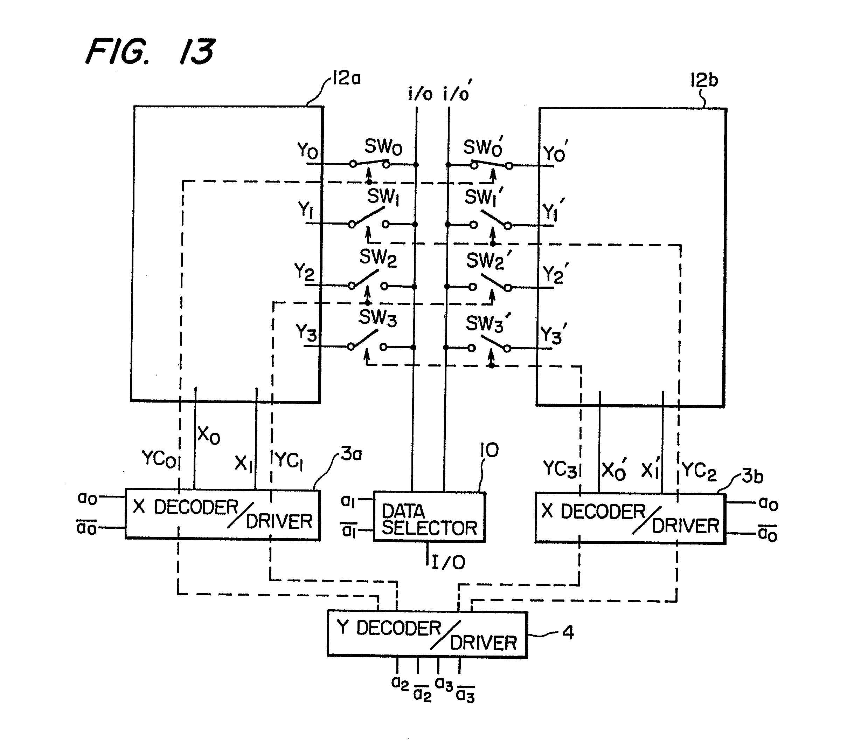

Whereas the arrangement of Fig. 12 has divided the word lines, an arrangement in Fig. 13 shows an example in which the data lines are divided into portions $Y_0$

- $Y_0'$, $Y_3$ - $Y_3'$.  The memory array is divided into sub arrays 12a, 12b.        -

In the present embodiment, the same address signal

lines $a_0$, $\overline{a_0}$ are connected to X decoders 3a, 3b disposed in correspondence with the respective sub arrays, and each of the X decoders selects either of two word lines.  The Y decoder 4 delivers a select signal to only one of four Y control lines.  Switches $SW_0$ - $SW_3$, which control

the connections between the data lines ($Y_0$ - $Y_3$) of

the sub array 12a and the input/output line i/o respectively,

and switches $SW_0'$ - $SW_3'$, which control the connections between the data lines ($Y_0'$ - $Y_3'$) of the sub array 12b and the input/output line i/o' respectively, are respectively operated by the signals of the common Y control lines 8.

Read signal voltages are simultaneously delivered to the input/output lines i/o and i/o', and one of them is selected by the data selector circuit 10 and is delivered to the input/output line I/O. The present embodiment has the advantage of easy manufacture because the pitch of the Y control lines 8 can be rendered great.

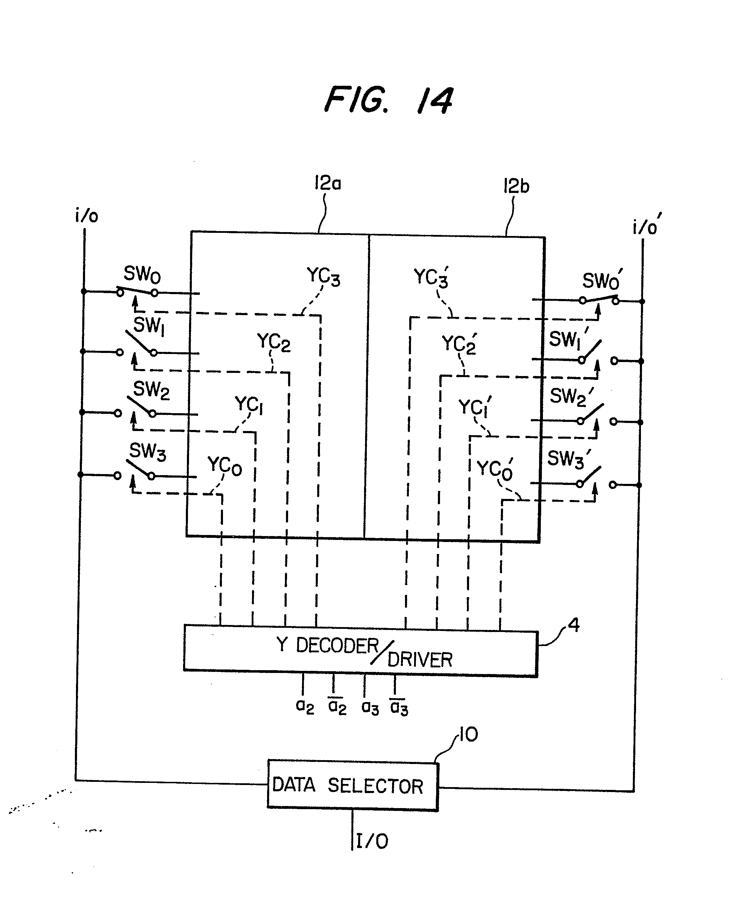

Fig. 14 shows an example in which the two sets of switches $SW_0 - SW_3$ and $SW_0' - SW_3'$ are arranged separate from each other. In the present embodiment, the Y decoder 4 has two sets of Y control lines $YC_0 - YC_3$ and $YC_0' - YC_3'$, which are respectively connected to the switches $SW_0 - SW_3$ and $SW_0' - SW_3'$ of the sub arrays 12a and 12b. The Y decoder selects one of the respectively two corresponding Y control lines.

When it is intended to simultaneously control, for example, the switches $SW_0$ and $SW_0'$ by means of the single Y control line 8 as illustrated in Fig. 13, there arises the inconvenience that the wiring leads of the second layer of aluminum indicated by dotted lines in the figure intersect the other Y control lines. Therefore, the switches $SW_0$ and $SW_0'$ must be individually controlled by the independent Y control lines ($YC_3$, $YC_3'$) within the specified sub arrays as in the circuit arrangement shown in Fig. 14. As a modification, when the Y decoder is constructed so as to be capable of selecting only any one of the eight control lines $YC_0 - YC_3$ and

$YC_0'$ - $YC_3'$, only either of the input/output lines i/o and i/o' can be supplied with a read signal. This brings forth the advantage that the other input/output line supplied with no output can be used as a signal line having another function. For example, in an arrangement wherein the Y control line is divided into a larger number of parts and wherein the sub arrays 12a, 12b are repeated in the lateral direction, the other input/output line as mentioned above can be diverted to the input/output line i/o or i/o' of another sub array.

In Fig. 13 or 14, the two read signals simultaneously delivered to the input/output lines i/o and i/o' need not be always selected into the single signal by the use of the data selector circuit 10. In some memories, it is desired to simultaneously deliver a large number of read signals out of the chip and to increase the quantity of utilizable data. In this case, the read signals may be directly delivered without passing them through the data selector circuit 10.

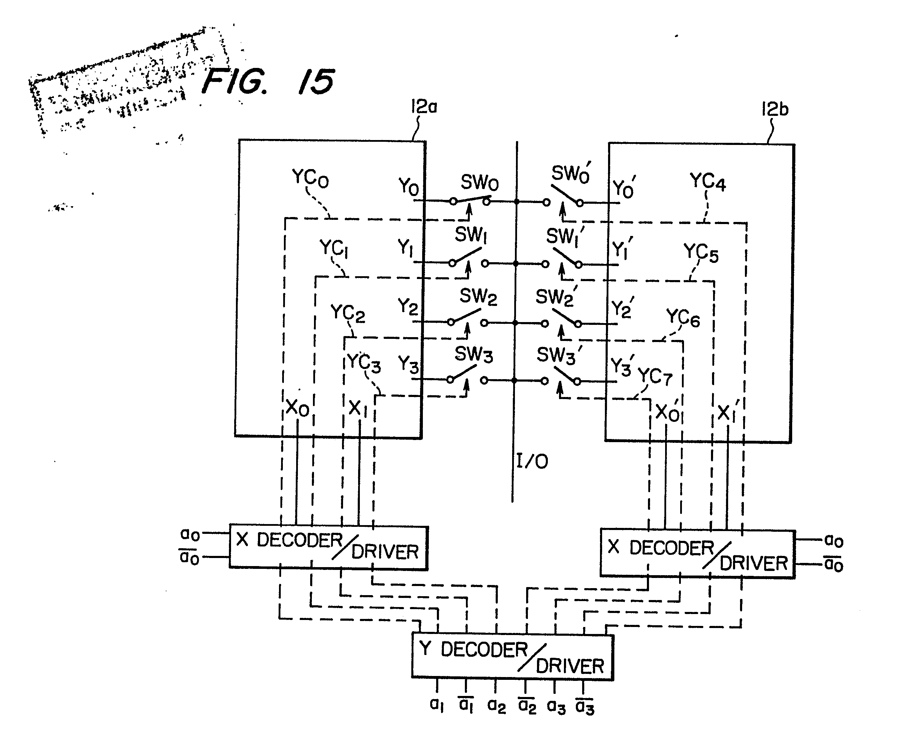

Fig. 15 shows an example in which one read signal output for the input/output line I/O is provided at all times. As compared with the arrangement of Fig. 13 or 14, the present embodiment can reduce the chip area to the extent that the input/output lines i/o, i/o' have changed into one. The switches $SW_0$, $SW_0'$ etc. are controlled by independent Y control lines $YC_0$, $YC_4$ etc. as in Fig. 14. However, in some cases, for example, where a large number of data are to be read out in parallel, two input/output lines I/O belonging to the switch $SW_0$ and to the switch $SW_0'$ can be prepared so as to derive read voltages to the two input/output lines I/O by simultaneously applying select pulses to the Y control lines, for example, $YC_0$ and $YC_4$ to simultaneously control the switches $SW_0$ and $SW_0'$.

The above examples of arrangements are applicable to all semiconductor memory cells such as the memory cells of a dynamic MOS memory, a flip-flop type static memory and a ROM. It has been presumed in the examples that each memory cell has the single data line (Y line), but it is obvious that the invention is also applicable to arrangements using pairs of data lines.

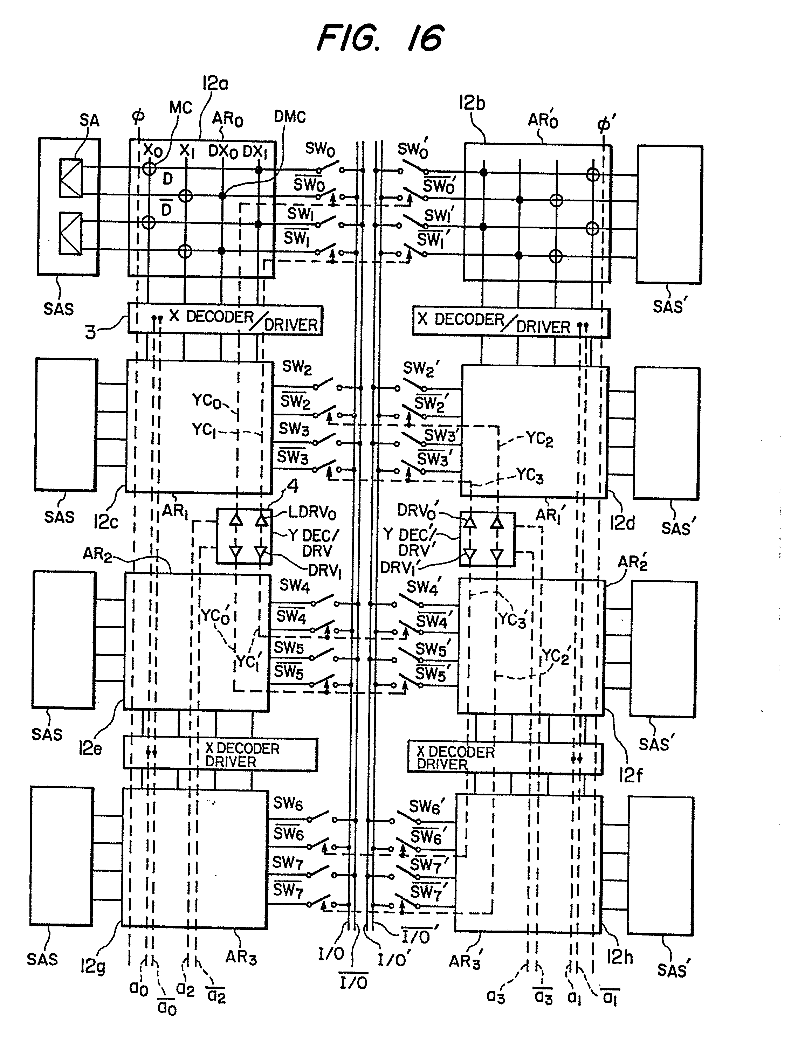

Fig. 16 shows a practicable embodiment for Fig. 12 which employs folded data line arrangement cells. Data lines are composed of pair lines $D$, $\overline{D}$, and one memory cell MC (white circle in the figure) constructed of a transistor and a capacitor connected to one of the two intersection points between the pair lines and a word line. In a case where the memory cell MC has been read out, for example, where a select pulse has

- 28 -

0136819

been impressed on the word line $X_0$ by an X driver 3 whereby a minute signal voltage corresponding to information "1" or "0" has been derived from the memory cell to the data line D, a dummy word line $DX_0$ is simultaneously selected by the X decoder 3, and a predetermined reference voltage is delivered from the dummy cell DMC (black circle in the figure) to the data line $\overline{D}$. When the reference voltage is set at the middle point of the signal voltages of the information "1" and "0", the read signal voltage is amplified by a sense amplifier SA to discriminate "1" or "0". As to the folded data line arrangement cell, the word line is formed of a material of comparatively high resistivity such as polycrystalline silicon or silicide, so that the memory device is divided in four in the direction of the word lines after the arrangement of Fig. 12. Since, in the present embodiment, the data lines are formed by the use of wiring leads of a first layer of aluminum, control lines ($YC_0$ - $YC_3$) are made of wiring leads of a second layer of aluminum. However, they may be wiring leads of the first layer of aluminum if the data lines of the folded data line arrangement cell are formed of a third layer of polycrystalline silicon by way of example. In this case, a problem in manufacture attendant especially upon the wiring leads of the second layer of aluminum is avoided, and there is the advantage of cost curtailment. Besides, the data pair lines and the Y control lines YC may well be made of the same material, for example, the first layer of aluminum. Here, when a Y decoder (including a driver) is arranged directly below a sub array 12a, the number of the Y control lines increases in the direction of the shorter side of the chip, and the Y control lines protrude from the sub array 12a in some shapes of matrices. Therefore, the Y decoder is arranged between sub arrays 12c and 12e as shown in the figure, thereby to halve the number of the Y control lines contributive to the direction of the shorter side of the chip. The present example is an example of application of Fig. 13, in which one Y control line, for example, $YC_0$ is used for controlling switches $SW_0$, $\overline{SW_0}$ and simultaneously switches $SW_0'$, $\overline{SW_0'}$ that belong to another sub array 12b. It is also possible, however, to lay independent control lines on the sub arrays 12a, 12b different from each other as in the modification of Fig. 15 and to use them for independently controlling the switches $SW_0$, $\overline{SW_0}$ and the switches $SW_0'$, $\overline{SW_0'}$ by way of example, thereby to derive amplified signal voltages to input/output lines I/0, $\overline{I/0}$, I/0', $\overline{I/0'}$ at the same time. Alternatively, one Y control line, for example,

$YC_0$ can be used for controlling two sets of switches $SW_0$, $\overline{SW_0}$, $SW_1$, $\overline{SW_1}$ as in Fig. 11. Of course, two pairs of input/output lines I/O are required in this case. Although, in the present example of arrangement, the switches are arranged on the side opposite to the sense amplifiers, it is also possible to arrange the switches in proximity to the sense amplifiers or to arrange the sense amplifiers in proximity to the switches. In general, however, arranging the sense amplifiers outside the arrays as shown in the figure makes it easier to lay out the sense amplifiers whose layout areas are prone to increase. The reason is that, since no circuit is disposed on one side, the space can be effectively used. Besides, the plurality of Y control lines 8 (assumed to be the three-dimensional wiring of the uppermost layer) may be wired in a shape enveloping the groups of switches to be controlled, as illustrated in the figure, in order to prevent them from crossing the arrays. Further, the Y control lines may be wired as illustrated in the figure in order to mitigate the complicacy of design relevant to wiring lead delays in such a way that the lengths of the Y control lines to pass on the sub array 12a and the lengths of the Y control lines to pass on the sub array 12b are equalized to the utmost. That is, the switches of the sub arrays 12a, 12b and those of the sub arrays 12e, 12f may be controlled by the Y control lines extended from the Y decoder on the left side, while the switches of the sub arrays 12c, 12d and those of the sub arrays 12g, 12h by the Y control lines extended from the Y decoder on the right side. In this regard, in case of controlling the switches $SW_1$, $\overline{SW_1}$ and $SW_1'$, $\overline{SW_1'}$ belonging to the sub arrays 12a and 12b by way of example, only one $DRV_0$ of two drivers for driving the two divided Y control lines respectively may be turned on to impress a pulse on the Y control line $YC_1$. In this case, the other driver $DRV_1$ must be turned off so as not to apply a pulse to the Y control line $YC_1'$. The reason is that two sorts of read signal voltages are simultaneously delivered (multiple selection) from the sub arrays 12a and 12b to the input/output lines $I/O$, $\overline{I/O}$, resulting in a malfunction. In the present embodiment, the lines of the address signals $a_0$, $\overline{a_0}$ determining the X decoder, the address signals $a_2$, $\overline{a_2}$ determining the Y decoder, etc. pass on the sub arrays as stated before. It is also possible to reduce the chip area in effect, in such a way that the lines of the other control signals $\phi$, $\phi'$ or the power source lines, which are not mentioned in the present example but have been stated before, are passed on the arrays throughout. The use of the folded bit line arrangement cells brings forth the advantage that, even when coupled voltages are induced in the same phase on the data pair lines D, $\overline{D}$ through coupling capacitances by the control signals $\phi$, $\phi'$, these voltages can be cancelled and rendered null in point of differential noise. It is sometimes necessary, however, to suppress even the inphase coupled voltages to small magnitudes. In this case, in order to reduce the number of control signals which couple to the same data pair lines D, $\overline{D}$, it is also possible to lay the lines of these control signals equally on the side of the sub array 12a and the side of the sub array 12b. Further, as a modification of the present embodiment, there can also be an arrangement in which the switches are controlled by the Y control lines belonging to the sides of the sub arrays 12a, 12b, as by using the Y control line $YC_0$ to control the switches $SW_0$, $\overline{SW_0}$, $SW_0'$, $\overline{SW_0'}$, the Y control line $YC_2$ to control the switches $SW_1$, $\overline{SW_1}$, $SW_1'$, $\overline{SW_1'}$, the Y control line $YC_1$ to control the switches $SW_2$, $\overline{SW_2}$, $SW_2'$, $\overline{SW_2'}$, and the Y control line $YC_3$ to control the switches $SW_3$, $\overline{SW_3}$, $SW_3'$, $\overline{SW_3'}$, and also using the Y control lines $YC_0' - YC_3'$ to perform similar controls.

Next, a method of wiring the Y control lines YC in the embodiment of Fig. 16 will be described in connection with folded bit line arrangement cells.

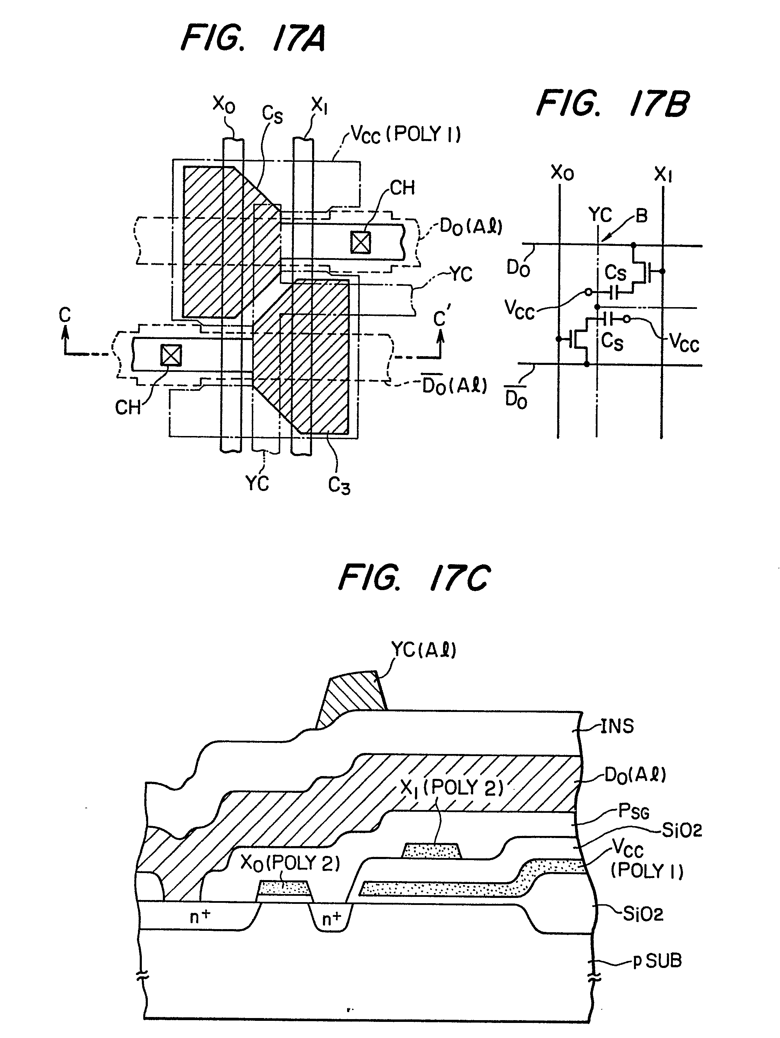

Fig. 17A is a layout plan of the folded bit line arrangement cell, Fig. 17B is a circuit diagram thereof, and Fig. 17C is a sectional view taken along line C - C' in Fig. 17A.

A storage capacitance $C_S$ in the memory cell is formed between a first layer of polycrystalline silicon (POLY1 in the drawing) and a p-type substrate pSUB with a thin oxide film $SiO_2$ therebetween, and it is formed in a hatched part in Fig. 17A. A data line $D_0$ is formed of aluminum which is connected with a diffused layer $n^+$ by a contact hole (CH in the drawing). Symbol INS in Fig. 17C denotes an inter-layer insulator film which is located between a data line $\overline{D_0}$ and a Y control line YC. Word lines X are formed of a second layer of polycrystalline silicon (POLY2). Here, the word lines may be made of silicide of lower resistivity or a material suited to self-alignment, such as molybdenum or tungsten. The data lines may well be formed of another layer different from the first layer of polycrystalline silicon (POLY1) or the second layer of polycrystalline silicon (POLY2). In this case, aluminum for the first layer of wiring can be used for the Y control lines YC as stated before. In a case where, as to such folded bit line arrangement cells, the Y control line YC wired on the array in parallel with the word line X is bent by 90 $^{\circ}$ midway to be laid in parallel with the data line $D_0$, the embodiment in the drawing serves to reduce noise coupled to the data pair lines by the Y control line YC or noise coupled to the Y control line by the word line X. More specifically, the Y control line YC is arranged between the word lines $X_0$ and $X_1$ so as to reduce the coupled capacitances thereof. This prevents the situation in which, when a pulse has been impressed on the selected word line, a voltage couples to the Y control line due to the capacitive coupling between the word line and the Y control line, so that the switch to be controlled by the Y control line turns on. Or, it prevents the situation in which, when a pulse has been impressed on the selected Y control line, a voltage couples to the non-selected word line to turn on the memory cells connected to this word line. In addition, in order to equally couple the Y control line with the data pair lines $D_0$, $\overline{D_0}$ so as to lessen differential noise to the data pair lines, the Y control line is intentionally coupled to the data line $D_0$ (point B in the drawing). For the same purpose, the Y control line is laid in the middle part between the data lines $D_0$ and $\overline{D_0}$.

A wide wiring lead such as the power source line is laid on a plurality of word lines.

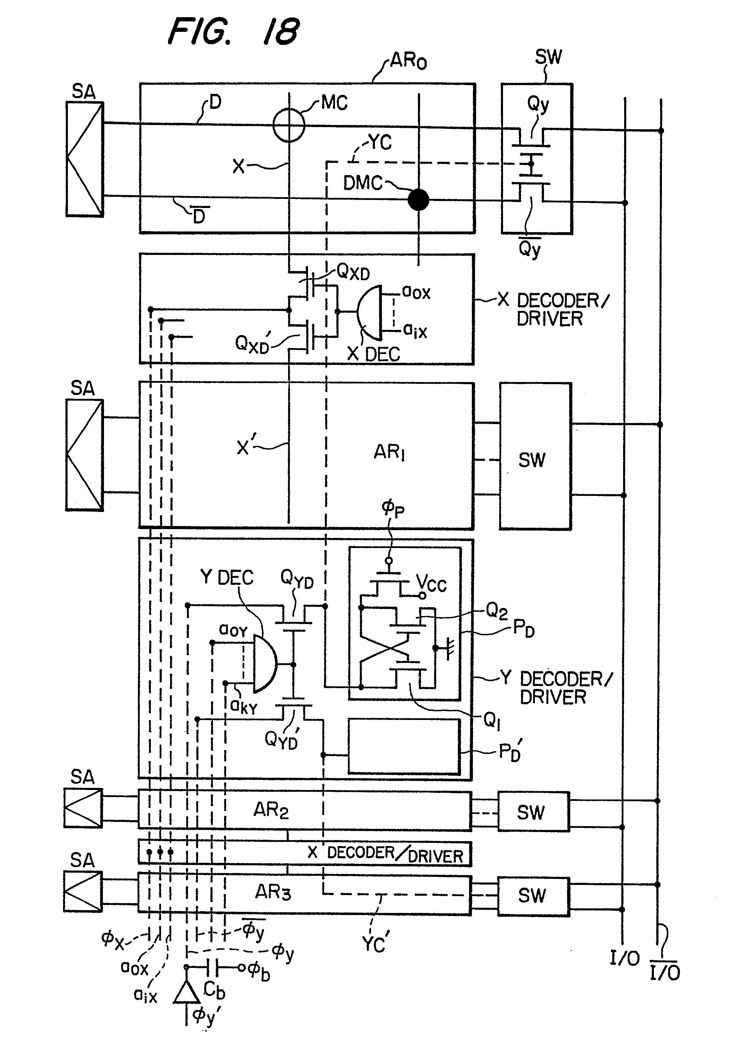

Fig. 18 shows a part of the circuit arrangement of Fig. 16 in detail. In the drawing, only one pair of data lines are shown in each sub array.

Known circuits such as a precharge circuit and an active restore circuit are usually connected to the data pair lines, but they are omitted from the present example because they are not directly pertinent to the essence of the invention. The sense amplifier SA in the figure is constructed of an ordinary flip-flop. In the present example, small signal voltages read out from the memory cell MC and the dummy cell DMC to the data pair lines are amplified by the sense amplifier SA, and they are delivered as differential outputs to the input/output lines I/O, $\overline{I/O}$ when transistors $Q_y$, $\overline{Q_y}$ are turned on by a pulse voltage applied to the selected Y control line YC. In a writing operation, as stated before, differential inputs corresponding to write data information are applied to the input/output lines I/O, $\overline{I/O}$ and are transmitted to the data pair lines through the selected switch SW, and the write data information is written into the selected memory cell. Here, the word line is selected as stated below. First, a select signal is provided from an X decoder (X DEC) in accordance with address signals $a_{0x}$, ......, $a_{ix}$ which run on

arrays related with the selection of the word lines, whereupon word pulses are applied to a plurality of sub word lines (X, X') through drivers $Q_{XD}$, $Q'_{XD}$ in accordance with a word line start signal $\phi_x$. In addition, address signals $a_{0Y}$, ....., $a_{kY}$ related with the selection of the Y control lines pass on the arrays, and a select signal is provided from a Y decoder (Y DEC) in accordance with them. Next, a Y control line start pulse is applied and only the specified Y control line is supplied with the pulse and controls the switch SW. Here, in order to reduce impedances at the turn-on of the transistors $Q_y$, $\overline{Q_y}$ in the switch SW, thereby to perform the exchanges of data between the data pair lines D, $\overline{D}$ and the input/ output lines I/O, $\overline{I/O}$ at high speed, the pulse voltage which is applied to the Y control line is controlled so as to have an amplitude sufficiently higher than a supply voltage. More specifically, assuming the supply voltage to be 5 V, when a pulse of 5 V is applied to a line $\phi'_y$, a pulse of 5 V is also delivered to the Y control line. On that occasion, a boosting clock signal $\phi_b$ having an amplitude of 5 V is applied from one end of a capacitor $C_b$. Thus, the Y control line is eventually fed with a pulse $\phi_y$ which is such that a voltage with the pulse amplitude of the signal $\phi_b$ divided by the capacitance of the capacitor $C_b$ and the parasitic capacitance of the Y control line is added
to the pulse $\phi'_y$. Such boosting technique has been
applied to word lines in a conventional dynamic memory
for the purpose of increasing charges to be stored in
memory cells, and the similar technique is also usable
for the Y control lines. In the figure, symbols PD
and PD' denote pull-down circuits for bringing non-
selected Y control lines into low impedances.

The pull-down circuit is provided in order to prevent
the Y control line from developing noise due to the
capacitive coupling with the word line, resulting in
the malfunction of the switch SW.

Before the reading or writing operation of the
memory cell, a high voltage is applied to the gate of
a MOS transistor $Q_1$ by a precharge signal $\phi_p$ so as to
turn on the MOS transistor $Q_1$. Thus, all the Y control
lines become low impedances which are governed by the
impedances of the MOS transistors $Q_1$, and the coupling
noise is rendered unlikely to be induced as described
before. Meanwhile, in a case where a MOS transistor
$Q_{YD}$ has been turned on by the Y decoder and where the
pulse $\phi_y$ has flowed to the Y control line, the MOS tran-
sistors $Q_{YD}$ and $Q_1$ perform a ratio operation, with the
result that a high voltage thereby determined is generated
on the Y control line. By this voltage, a MOS transistor

$Q_2$ is turned on, and the gate voltage of the MOS transistor $Q_1$ becomes 0 V to turn off this MOS transistor $Q_1$. Since the ratio operation continues for a short time, the power consumption does not increase. In a case where the layout area for the pull-down circuits PD, PD' etc. enlarges to pose a problem, a single control system may be formed without preparing the two perfectly independent control systems which include the pulse lines $\phi_y$, $\overline{\phi_y}$, drivers $Q_{YD}$, $Q'_{YD}$ and Y control lines YC, YC'. Thus, the Y control lines YC and YC' can be unified into a single control line, so that one pull-down circuit suffices. In this case, however, if the switches SW to be selected belong to the sub arrays $AR_0$ and $AR_3$, separate input/output lines I/O, $\overline{I/O}$ need to be respectively disposed for the sub arrays $AR_0$ and $AR_3$.

While, in the above embodiment, a flip-flop circuit has been employed as the pull-down circuit, it can be replaced with a single transistor whose gate is supplied with a fixed voltage when the occupying area of layout poses a problem.

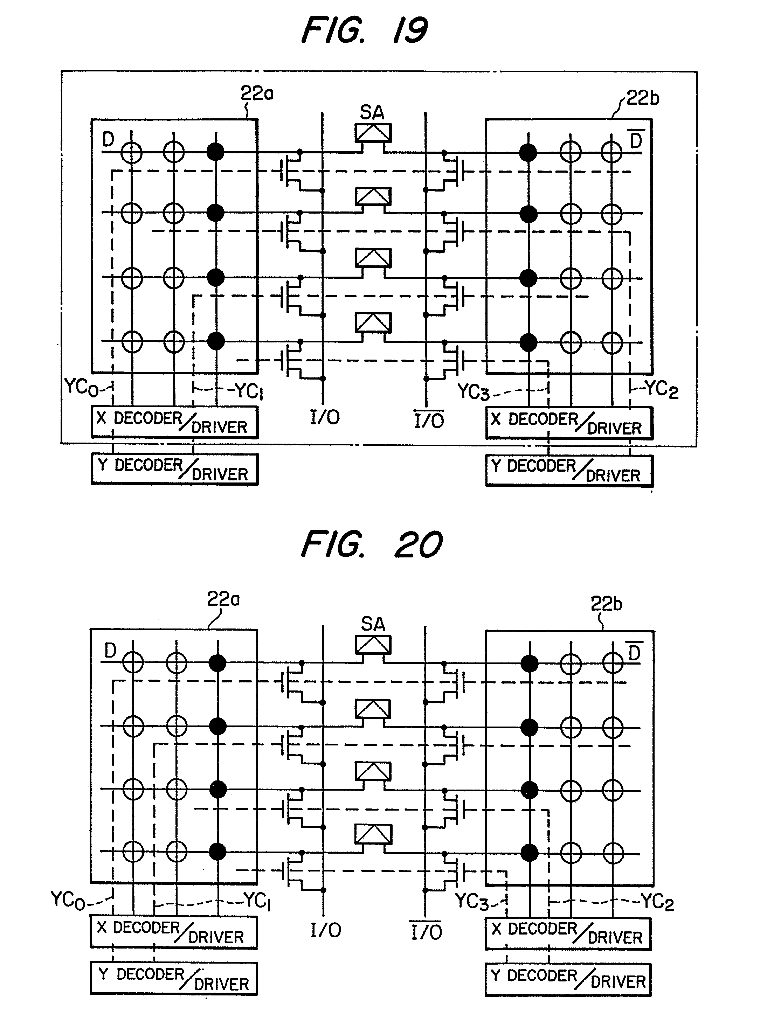

Fig. 19 shows an example in which the present system is applied to the dynamic memory cell of an open data line arrangement cell. White circles in arrays indicate memory cells, and black circles dummy cells. The structure is detailed in the paper mentioned before. The present example is an example in which switches confront the inner sides of the arrays 22a, 22b. It differs from the arrangement of Fig. 13 in the following point. In the case of Fig. 13, the memory cells belonging to the sub arrays 12a, 12b are independently selected, and the two independent data are applied to or from the input/output lines i/o, i/o', whereas in the embodiment of Fig. 19, one data is applied to or from the input/ output line I/O or $\overline{I/O}$, and it is differentially applied. In the present example, in order to hold the electrical balance between data pair lines D, $\overline{D}$, a Y control line is laid in parallel with the respective data lines D, $\overline{D}$ so as to have equal coupled capacitances with both the data lines D, $\overline{D}$. The Y control lines are extended alternately from right and left Y decoders. However, when the Y control line is lengthened in order to equalize the coupled capacitances, it intersects another Y control line. Therefore, it is possible to equalize the length over which the Y control line and the data line D couple and the length over which the Y control line and the data line $\overline{D}$ couple. Accordingly, the electrical unbalance between the data lines D and $\overline{D}$ is liable to occur, resulting in great noise.

An embodiment in Fig. 20 is basically the same as the circuit arrangement of Fig. 19, and it differs only in that the Y control lines of the left Y decoder and those of the right Y decoder are arranged in the order of the data lines as reckoned from the uppermost one. Also in this case, likewise to the above, the data lines D, $\bar{D}$ become electrically unbalanced.

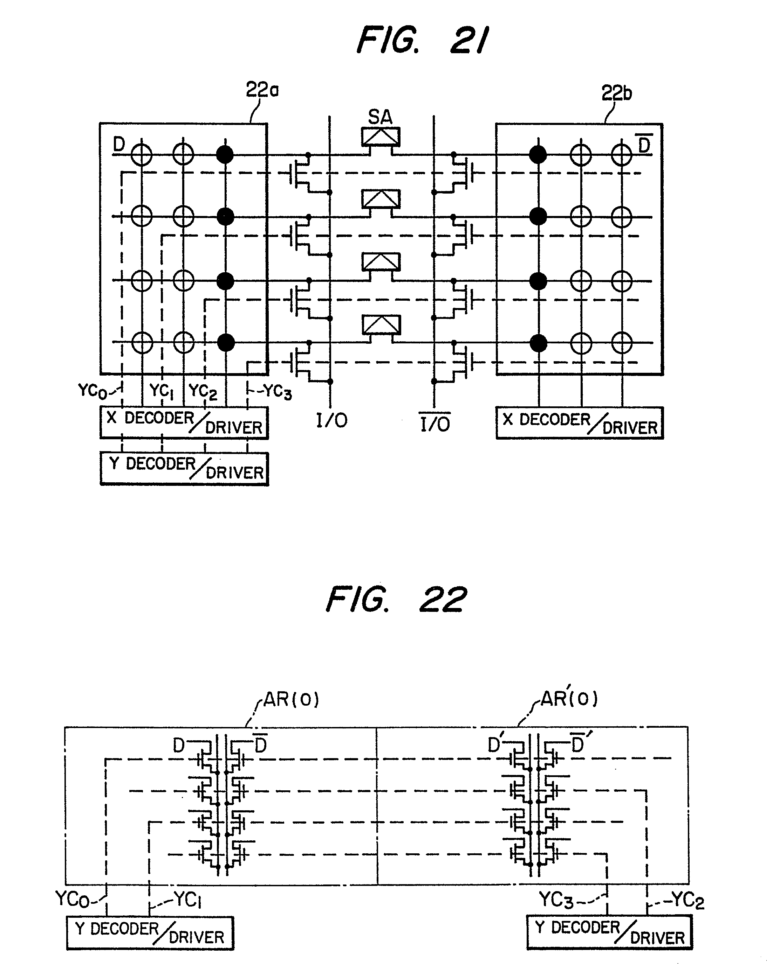

Also an embodiment in Fig. 21 is basically the same as the circuit arrangement of Fig. 19, and it differs only in that all the switches are selected by the Y decoder disposed on the left side. Also in this case, the data lines D, $\bar{D}$ similarly become electrically unbalanced.

With the circuit arrangements of Figs. 19 - 21, when various timing pulse signal lines for controlling the memory operation (for example, the signal line of the signal $\phi$ in Fig. 2A) are passed through the array, they couple with the data lines of the data pair lines on one side, and hence, differential noise is liable to develop. Accordingly, the number of the signal lines which can pass on the array is limited, so that shortening the shorter side of the chip is more limited than in the case of the folded data line arrangement cells. However, when compared with the folded data line arrangement cells, the open data line arrangement cells permit the word lines to be formed of aluminum of low resistivity and therefore need not divide the memory
in the direction of the word lines. Accordingly, they
have the advantage that the longer side of the chip
can be rendered smaller than in the case of the folded
data line arrangement cells. The open data line arrangement cells are, in general, inferior in the signal-to-
noise ratio, and in order to improve this drawback, the
system of dividing the data lines as in Fig. 13 is common.
In this case, there is a method in which the arrangement
of Fig. 19 is simply multiplexed. That is, when the entirety
of Fig. 19 is deemed a sub array AR(0), the arrangement
of the sub array AR(0) is repeated in the direction of
the data lines. In other words, the Y control lines
are completed within the sub arrays AR, $\overline{AR}$ to which
one set of sense amplifiers belong. Another method
is such that, as shown in Fig. 22, Y control lines are
laid and controlled in common between larger sub arrays
AR(0), AR'(0). It is obvious that the data lines can
be divided similarly on the basis of the concepts in
Figs. 20 and 21.

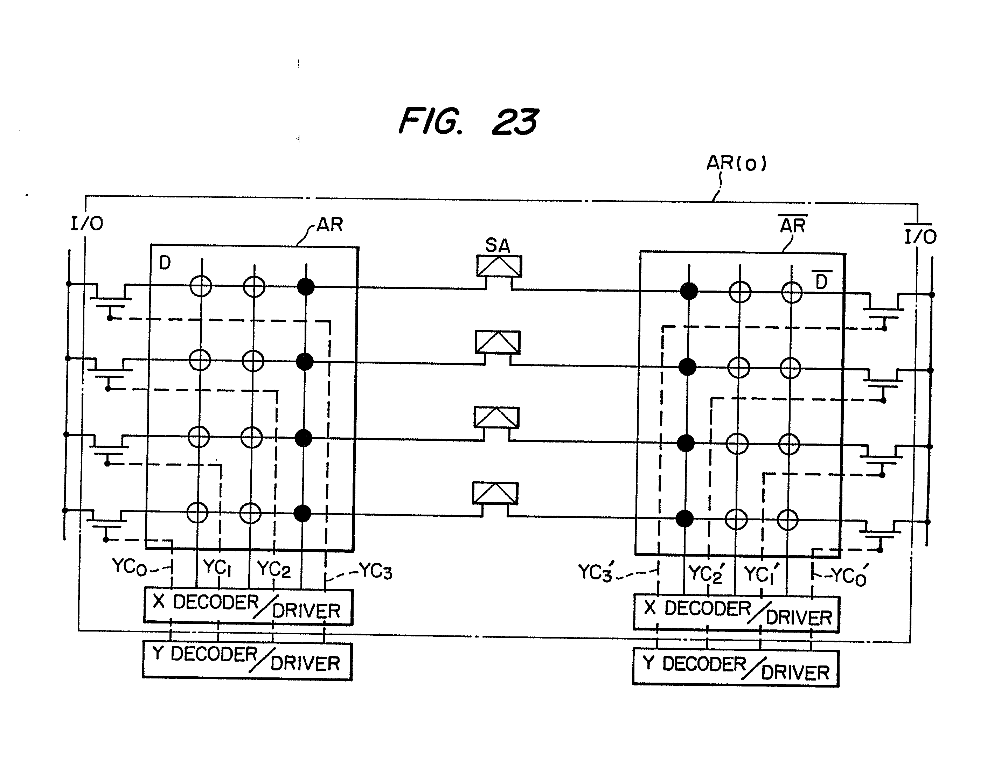

Fig. 23 shows an embodiment in the case where, as
regards the open data line arrangement cells, switches
SW are arranged at ends remote from sense amplifiers
SA. In general, the layout area of the sense amplifiers
SA becomes large, so that when the switches are laid out in proximity thereto, the electrical balance between the data pair lines becomes difficult to be held. Therefore the present embodiment which separates the switches away from the sense amplifiers SA is important in practical use. Formally, the present embodiment is also considered a practical example of the arrangement of Fig. 14. However, in the arrangement of Fig. 14, the two data independent of each other are applied to or from the input/output lines i/o, i/o', whereas in the embodiment of Fig. 23, one data is differentially applied to or from the input/output line I/O or $\overline{I/O}$. The advantage of the present embodiment is that the electrical balance of the respective data pair lines is substantially perfect. The reason is that the data lines D, $\overline{D}$ and Y control lines $YC_3$, $YC_3'$ are capacitively coupled substantially equally. In operation, two corresponding Y control lines such as the Y control lines $YC_3$ and $YC_3'$, those $YC_2$ and $YC_2'$, those $YC_1$ and $YC_1'$ or those $YC_0$ and $YC_0'$ are always selected by Y decoders, and the data of the memory cell selected by an X decoder is exchanged between the corresponding data pair line and the input/output line I/O or $\overline{I/O}$.

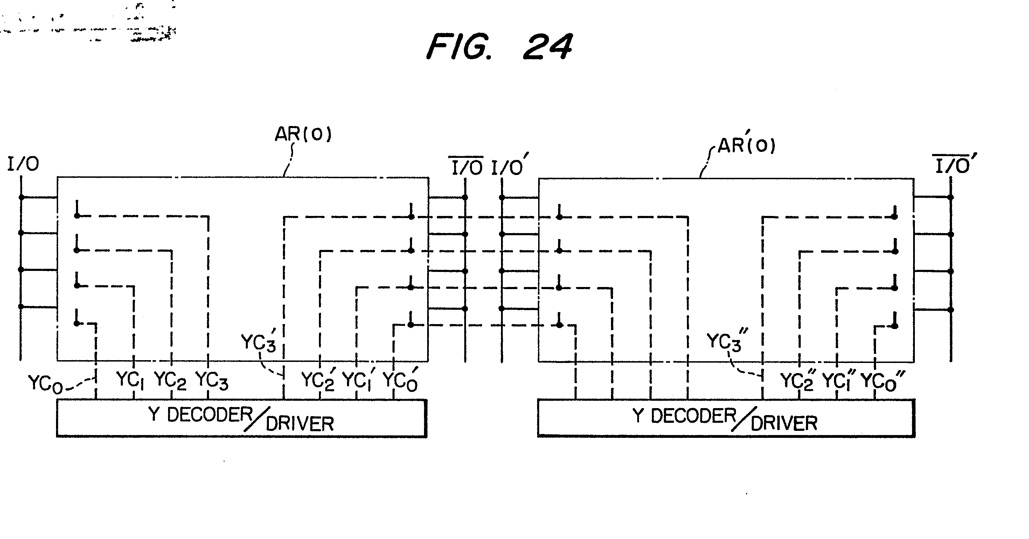

Fig. 24 shows an expanded example of the arrangement of Fig. 23 corresponding to Fig. 22 in which the data lines are divided. Switches on the sides of input/

output lines I/O, I/O', which belong to sub arrays AR(0) and AR'(0), are controlled by the same Y control lines. Y control lines $YC_3$, $YC_3'$, $YC_3''$ are simultaneously selected, and data are exchanged with two pairs of input/output lines I/O, $\overline{I/O}$, I/O', $\overline{I/O'}$.

The concrete wiring of the Y control lines for the open data line arrangement cells may be similar to that of Fig. 17.

While, in the above, the practicable embodiments have been described by taking the dynamic memory as an example, the relationship of the mutual positions of an X decoder and a Y decoder and the control method employing Y control lines YC to be controlled by the Y decoder, as well as the wiring method thereof, are common to all semiconductor memories. Therefore, the present invention is applicable to other semiconductor memories , with the result that reduction in the chip size is permitted. In addition, while the effect of shortening the length of the shorter side of a chip has been chiefly described in the above examples, it is obvious that the invention is similarly applicable when the length of the longer side of the chip is to be shortened. This is apparent from the subject matter of the present invention that decoders and drivers may be prevented from being arranged in the direction in which the chip dimension is to be shortened.

Since, as the result of the above, the semiconductor memory according to the present invention can be rendered slender, an elongate package preferably made of plastics can be used. As a result, the invention can reduce the packaging cost.

As described above, according to the present invention, one side of a chip can be shortened, and this is convenient for application to an elongate package.

While, the invention do not only applies for a memory device having data lines for both inputing and outputing memory signals, but also applies for a memory device having two types of data lines, such that one type is for inputing memory signal and the other type is for outputing memory signal.

Claims:

1.      A semiconductor memory comprising a plurality of data lines ($Y_0$ to $Y_3$), a plurality of word lines ($X_0$ to $X_3$) which are arranged so as to intersect said plurality of data lines ($Y_0$ to $Y_3$), a plurality of memory cells (MC) which are respectively disposed at the intersections of the plurality of data lines ($Y_0$ to $Y_3$) and the plurality of word lines ($X_0$ to $X_3$), a row decoder (3) which selects at least one of the plurality of word lines ($X_0$ to $X_3$), and a column decoder (4) which generates a signal for connecting one of the plurality of data lines ($Y_0$ to $Y_3$) to a common line I/O;

characterised in that:

the memory has a plurality of wiring leads (P) which are formed of a conductor layer different from the conductor layer or layers forming the plurality of data lines ($Y_0$ to $Y_3$) and the plurality of word lines ($X_0$ to $X_3$) and which are arranged so as to intersect the plurality of data lines ($Y_0$ to $Y_3$).

2.      A semiconductor memory according to claim 1, wherein the plurality of wiring leads (P) includes at least one power source line ($V_{CC}$).

3.      A semiconductor memory according to claim 1 or claim 2, wherein the plurality of wiring leads (P) includes at least one signal line $\emptyset$ for signals controlling operation timings of the semiconductor memory.

4.    A semiconductor memory according to any one of claims 1 to 3, wherein the row decoder (3) orthogonally intersects the lengthwise direction of the plurality of word lines ($X_0$ to $X_3$), and the column decoder (4) orthogonally intersects the lengthwise direction of the plurality of data lines ($Y_0$ to $Y_3$).

5.    A semiconductor memory according to any one of claims 1 to 4, wherein the wiring leads (P) are arranged so as to capacitively couple with at least two of the word lines ($Y_0$ to $Y_3$).

6.    A semiconductor memory according to any one of claims 1 to 5 having at least one sense amplifier, the or each of which is adapted to differentially amplify signals of two of the data lines, and those two data lines are arranged in parallel so as to be capacitively coupled with the wiring leads equally.

7.    A semiconductor memory according to claim 6, wherein a memory cell is arranged at only one of the two intersection points between a word line and the two data lines which have signals to be differentially amplified.

8.    A semiconductor memory according to claim 7, having a circuit which is adapted to precharge the two data lines to a voltage substantially intermediate to two sorts of voltages to be written into the memory cell, before said word line is driven.

9.    A semiconductor memory according to claim 8, having an active restore circuit between two data line pairs to be differentially amplified, which is connected to the two data line pairs through first and second switches operating selectively, to charge the data line on a high potential side of the two data line pairs amplified by said sense amplifier.

10.     A semiconductor memory according to any one of claims 6 to 9, wherein the or each sense amplifier has two data line pairs to be differentially amplified, on both its sides, and is or are connected to the two data line pairs through first and second switches operating selectively.

11.     A semiconductor memory according to claim 9, having common lines between the two data line pairs and which are selectively connected to the two data line pairs by the first and second switches.

12.     A semiconductor memory according to any one of the preceding claims, wherein the plurality of data lines are divided into a plurality of sub data lines in a lengthwise direction thereof; the memory also having a plurality of common lines each of which is disposed in common for at least two of the sub data lines and is connected to these sub data lines through a third switch, and control lines which are adapted to transmit select signals generated by the column decoder to the third switches in order to drive the third switches and are disposed in parallel with the sub data lines.

13. A semiconductor memory according to claim 12, wherein the sub data lines and the control lines are formed of a first layer of aluminium, the wiring leads are formed of a second layer of aluminium, and the word lines are formed of a self-alignment material.

14. A semiconductor memory according to claim 12, wherein the control lines and the wiring leads are formed of a first layer of aluminium, the sub data lines are formed of a second layer of aluminium, and the word lines are formed of a self-alignment material;

those of the third switches which are connected to a plurality of sub data lines remotest from the column decoder are disposed on the column decoder sides of the sub data lines; and

the wiring leads are arranged so as to intersect the remotest sub data lines.

15. A semiconductor memory according to claim 12 wherein the plurality of word lines are divided into sub word lines in a lengthwise direction thereof; and

the row decoder has the divided sub word lines on upper and lower sides thereof and includes means to selectively drive the sub word lines on one of the upper and lower sides.

16. A semiconductor memory according to claim 1, wherein the plurality of data lines are divided into sub data lines in a lengthwise direction thereof,

the column decoder has the sub data lines on right and left sides thereof,

a plurality of common lines are disposed in common for at least two of the sub data lines and are connected to these sub data lines through third switches,

control lines are respectively disposed in parallel with the sub data lines on the right and left sides of the column decoder and which are formed of the same conductor layer as that of the wiring leads, and are adapted to transmit select signals generated by said column decoder, to said third switches in order to drive them,

those of said third switches which are connected to two sets of sub data lines remotest from the right and left sides of the column decoder respectively are disposed on the column decoder side of the sub data lines, and

the wiring leads are arranged so as to intersect the two sets of sub data lines remotest from the right and left sides of the column decoder respectively.

17. A semiconductor memory according to claim 1, wherein the row decoder and said column decoder are arranged in parallel with each other, and

drive signals for fourth switches which connect the plurality of data lines and said common lines are transmitted from the column decoder by control lines which are formed of the same conductor layer as that of the wiring leads and which pass within a region where the data lines and the word lines exist.

18. A semiconductor memory according to claim 17, wherein said column decoder and the row decoder are arranged in proximity to each other.

19. A semiconductor memory according to claim 17, wherein the plurality of word lines are divided into a plurality of sub word lines in a lengthwise direction thereof, and

the row decoder has the sub word lines on right and left sides thereof and selects them respectively.

20. A semiconductor memory according to any one of claims 17 to 19, including a circuit which clamps the control lines when they are not selected.

21. A semiconductor memory according to any one of the preceding claims, wherein the memory cell has a transistor whose control terminal is connected to a corresponding word line, and a capacitance portion whose connection with a corresponding data line is controlled by the transistor.

22. A semiconductor memory according to any one of the preceding claims, wherein the row decoder and the column decoder include drivers for driving the word lines and the data lines respectively.

23. A semiconductor memory according to any one of the preceding claims, wherein the data lines are formed of aluminium, and the word lines are formed of a self-alignment material.

FIG. 1

# FIG. 2A

*FIG. 2B*

P(Aℓ)

SiO2

Yo(Aℓ)

SiO2

Xo(POLY)

P-SUB

*FIG. 3*

P    AR

Xo    X₁

MC

Yo

Y₁

*FIG. 4*

P    AR

Xo    X₁

SA

Do
D̄o

D₁
D̄₁

4

0136819

## FIG.5A

X DECODER / DRIVER — 3

## FIG.5B

## FIG.5C

INS
(Aℓ) DATA
X' (POLY 2)
PSG
SiO2
Vcc (POLY I)
SiO2
n+    n+
X (POLY 2)  Cs
pSUB
CH

## FIG. 5D

## FIG. 6

FIG. 7

FIG. 8

# FIG. 10

FIG. II

FIG. 12

0136819

*FIG. 13*

FIG. 14

FIG. 15

FIG. 16

0136819

15

0136819

## FIG. 17A

## FIG. 17B

## FIG. 17C

# FIG. 18

16

0136819

## FIG. 19

22a    SA    22b

D    D̄

YC₀    YC₁    YC₃    YC₂

| X DECODER/DRIVER |    I/O    I/O̅    | X DECODER/DRIVER |

| Y DECODER/DRIVER |    | Y DECODER/DRIVER |

## FIG. 20

22a    SA    22b

D    D̄

YC₀    YC₁    YC₃    YC₂

| X DECODER/DRIVER |    I/O    I/O̅    | X DECODER/DRIVER |

| Y DECODER/DRIVER |    | Y DECODER/DRIVER |

0136819

# FIG. 21

# FIG. 22

FIG. 23

FIG. 24

0136819